# EUROPEAN PATENT APPLICATION

(11) **EP 4 697 684 A1**
(43) Date of publication of application: **18.02.2026**
(21) Application number: 24845725.1
(22) Date of filing: 09.04.2024
(51) Int. Cl.: H04M 1/02, H05K 5/02

(54) **PORTABLE COMMUNICATION DEVICE INCLUDING GEAR INTERLOCKING STRUCTURE**

(30) Priority: 26.07.2023 KR 20230097596; 21.08.2023 KR 20230109229
(71) Applicant: Samsung Electronics Co., Ltd., Suwon-si, Gyeonggi-do 16677 (KR)
(72) Inventor: JUNG, Iksu, Suwon-si Gyeonggi-do 16677 (KR); KIM, Jongkeun, Suwon-si Gyeonggi-do 16677 (KR); RYU, Myungchul, Suwon-si Gyeonggi-do 16677 (KR); PARK, Yeongmin, Suwon-si Gyeonggi-do 16677 (KR); LEE, Dongik, Suwon-si Gyeonggi-do 16677 (KR); CHO, Sunggun, Suwon-si Gyeonggi-do 16677 (KR); YOO, Minwoo, Suwon-si Gyeonggi-do 16677 (KR)
(74) Representative: Appleyard Lees IP LLP
(86) International application number: PCT/KR2024/004720
(87) International publication number: WO 2025/023421

(57) **Abstract**

A portable communication device includes a first housing, a second housing, a first main gear functionally connected to the first housing, rotated in a first rotational direction, and including first main gear teeth, of which widths gradually increase in a direction perpendicular to the first rotational direction, a second main gear functionally connected to the second housing and rotated in a second rotational direction opposite to the first rotational direction in interlocking with movement of the first main gear, and a first interlocking gear disposed between the first main gear and the second main gear and coupled to the first main gear to interlock movement of the first main gear with the second main gear, the first interlocking gear including teeth, of which widths gradually decrease such that the teeth are engaged with the first main gear teeth.

## Description

### BACKGROUND

### 1. Field

Various embodiments of the disclosure relate to a portable communication device including a gear interlocking structure.

### 2. Description of Related Art

A portable electronic device, such as a smartphone, a tablet, a notebook computer, a slate personal computer (PC), or a laptop computer, may support a call function and various content searching and providing functions based on various types of applications. The portable electronic device may output a screen corresponding to each function in a process of providing various functions. When the user uses the above-described various functions, the user may want to use a wider screen. In general, when a display device is to be expanded for screen display in a portable electronic device, the overall size of the electronic device has to be increased, which may deteriorate portability. Accordingly, a portable electronic device, in which a display is folded to increase the size of the screen while maintaining portability has been provided. Such a portable electronic device may have folded and unfolded states. A portable electronic device may include a plurality of housings configured to support respective areas of a display in an unfolded state, and a hinge structure that interconnects the plurality of housings. The information may be provided as related art to help understanding the disclosure. None of the above may be claimed as a prior art related to the disclosure or used to determine the prior art.

### SUMMARY

According to an aspect of the disclosure, there is provided a portable communication device including: a housing including a first housing, and a second housing configured to be movable relative to the first housing to be in a folded state or a non-folded state with respect to the first housing; a first main gear connected to the first housing and configured to be rotated in a first rotational direction, wherein the first main gear includes first main gear teeth, wherein each of the first main gear teeth have a width that gradually increases in a direction perpendicular to the first rotational direction; a second main gear connected to the second housing and configured to be rotated in a second rotational direction opposite to the first rotational direction in interlocking with movement of the first main gear; and a first interlocking gear provided between the first main gear and the second main gear and coupled to the first main gear to interlock movement of the first main gear with the second main gear, wherein the first interlocking gear includes teeth, each of the teeth of the first interlocking gear has a width that gradually decreases, and the teeth of the first interlocking gear are engaged with the first main gear teeth of the first main gear.

### BRIEF DESCRIPTION OF THE DRAWINGS

FIG. 1 is a perspective view illustrating an example of a portable communication device in an unfolded state and a folded state according to an embodiment;
FIG. 2 is a view illustrating an example of an exploded perspective view of some components of a portable communication device in an unfolded state according to an embodiment;
FIG. 3 is a view illustrating an example of an exploded perspective view of a hinge structure according to an embodiment;
FIG. 4 is a view illustrating at least some of components related to a gear interlocking structure according to an embodiment;
FIG. 5 is a view illustrating an exploded view of at least some of components related to a gear interlocking structure according to an embodiment;
FIG. 6 is a view illustrating an example of a shape of a main gear according to an embodiment;
FIG. 7 is a view illustrating an example of a shape of an interlocking gear according to an embodiment;
FIG. 8 is a perspective view illustrating a coupled form of gears according to an embodiment;
FIG. 9 is a front view illustrating a coupled form of gears according to an embodiment;
FIG. 10 is a view related to a description of an operation situation of a gear interlocking structure of a hinge structure according to an embodiment;
FIG. 11 is a view illustrating some components related to a gear interlocking structure of a hinge structure according to an embodiment;
FIG. 12 is a view illustrating a partial cross-section of a gear interlocking structure according to an embodiment;
FIG. 13 is a view illustrating another partial cross-section of a gear interlocking structure according to an embodiment;
FIG. 14 is a view illustrating an example of a second type gear interlocking structure included in a hinge structure according to an embodiment;
FIG. 15 is a view illustrating an example of some components of a hinge structure including a third type gear interlocking structure according to an embodiment;
FIG. 16 is a view illustrating an example of a hinge structure including a fourth type gear interlocking structure according to an embodiment; and
FIG. 17 is a view illustrating an example of another form of a foldable electronic device including a hinge structure having a gear interlocking structure according to an embodiment.

### DETAILED DESCRIPTION

Hereinafter, various embodiments of the disclosure may be described with reference to accompanying drawings.

For example, hereinafter, according to a communication device (or a portable electronic device or a foldable electronic device) according to various embodiments of the disclosure, by applying an inclination (or a gradient) to at least some of the gears included in at least one hinge structure, backlash due to gaps between the gears may be reduced during rotation thereof, so that the gears may be rotated more firmly and stably.

As an example, the portable communication device (or the foldable electronic device) of the disclosure may include at least one hinge structure, and the at least one hinge structure may include at least one gear to which a gradient is applied. For example, the gear may include gear teeth, and at least some of the gear teeth may include a gradient area (or a gradient shape, an inclined area having an inclination angle that is greater or less than 0, or an inclined area having a specific inclination with respect to a horizontal reference). Alternatively, at least some of gear teeth of at least one gear included in a hinge structure according to an embodiment may include a flat area (or a flat shape, or a non-gradient area) and a gradient area. Alternatively, gear teeth of at least one gear included in the hinge structure according to an embodiment may include a first gradient area having a first inclination in one direction and a second gradient area having a second inclination in another direction that is different from the one direction. The first inclination and the second inclination may have the same magnitude.

When the gears are engaged and rotated, backlash may occur. Backlash may correspond, for example, to an aperture (or a gap) that is formed in a movement direction in a mechanism or a structure in which members, such as gears, screws, or toothed wheels, are engaged with each other to be moved. This aperture may be a specific space that is necessary for gears, screws, or toothed wheels to be move freely or to be rotated smoothly. Backlash may gradually increase due to wear in response to movement of gears. Backlash may cause vibration or noise, or may cause a reduction in a lifespan of a mechanical structure. As an example, because an engagement space is accumulated as the number of engaged gears increases in a gear structure, backlash increases in proportion to the number of interlocked gears. When backlash occurs, the second housing connected to the first housing through a hinge structure is not rotated even when the first housing of a portable communication device (or a foldable electronic device) is rotated within an angle, at which the backlash occurs, and thus, a free-play section (e.g., a section in which the housings are rotated even under a pressure that is less than a reference value) due to non-interlocking may be generated. When the free-play section is generated, the foldable electronic device may be unfolded even in a situation in which the user does not intend to unfold it, or the housings may be widened or collide with each other by gravity, external pressure, or rotational force. For example, in an embodiment of the disclosure, by maintaining an engagement between gears more closely and stably, the above-described backlash may be improved so that a stable hinge operation may be supported. The objects according to various embodiments of the disclosure will be described as necessary in a process of describing the embodiments.

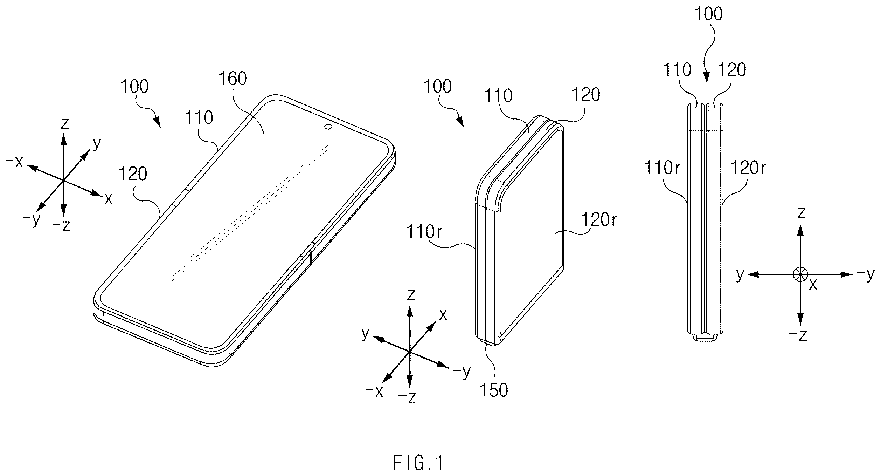

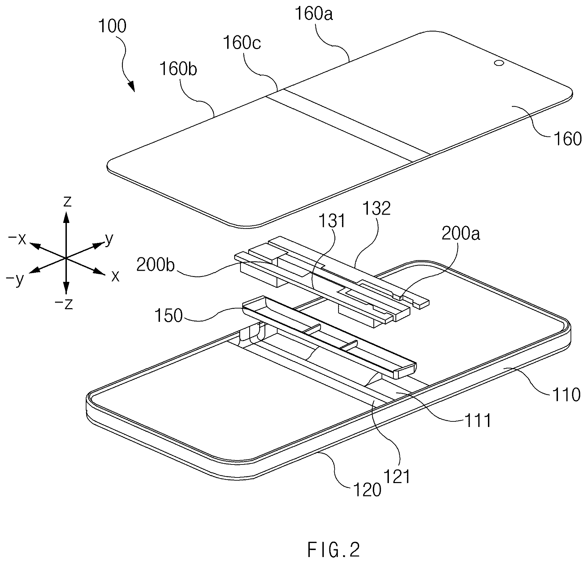

FIG. 1 is a perspective view illustrating an example of a portable communication device in an unfolded state and a folded state according to an embodiment, and FIG. 2 is a view illustrating an example of an exploded perspective view of some components of the portable communication device in an unfolded state according to an embodiment.

Referring to FIGS. 1 and 2, a portable communication device 100 (or a foldable electronic device or an electronic device, hereinafter, the foldable electronic device) may include housings including a first housing 110 and a second housing 120, a display 160 (e.g., a flexible display), a hinge structure 200a and 200b (or a hinge structure or a hinge), and a hinge housing 150 in which at least a portion of the hinge structures 200a and 200b is disposed. Furthermore, at least one of a modem, a transceiver, an antenna for cellular communication, an antenna for short-range communication, and a wireless charging coil may be accommodated in the first housing 110 and/or the second housing 120 of the portable communication device 100.

FIG. 1 is a perspective view of the foldable electronic device 100 in a flat state, an unfolding state, and an unfolded state, and a perspective view in a folded state, and FIG. 2 is a perspective view of an exploded state of some components of the foldable electronic device 100 in the unfolded state. Additionally or alternatively, the foldable electronic device 100 may further include a first cover 110r that covers a rear surface of the first housing 110 and a second cover 120r that covers a rear surface of the second housing 120. Alternatively, a separate auxiliary display may be further disposed on a rear surface (or a front surface) of the first housing 110.

According to an embodiment, the hinge housing 150 may be a part of the first housing 110 or the second housing 120.

According to an embodiment, the first housing 110, the second housing 120, and the hinge housing 150 may be parts of one housing.

According to an embodiment, the first cover 110r, the second cover 120r, and the hinge housing 150 may be parts of one housing.

According to an embodiment, the first housing 110 may be disposed continuous to the second housing 120 depending on a disposition state thereof (e.g., when a central portion 160c of the display 160 is unfolded flatly or when the housings are in an unfolded state), or may be disposed in parallel to the second housing 120. Alternatively, when the central portion 160c of the display 160 is folded, one surface of the first housing 110 may be disposed to face one surface of the second housing 120.

The first housing 110 may be, for example, at least partly formed of a metallic material, or at least partly formed of a non-metallic material. For example, the first housing 110 may be formed of a material having a specific rigidity to support at least a portion of the display 160. One area (e.g., an upper portion 160a of the display 160) (or one area in the x-axis direction or a first area, or a portion of the central portion 160c) may be disposed at at least a portion of a front surface part of the first housing 110. At least a portion of the first housing 110 may be coupled to an upper portion 160a of the display 160 (e.g., coupled or adhered to at least a portion of a rear surface (e.g., an opposite surface to a direction that faces the display 160)). Alternatively, at least a portion of a periphery of a front surface (e.g., one surface that faces the z-axis direction) of the first housing 110 may be coupled to (disposed at or adhered to) at least a portion of the upper portion 160a of the display 160 while surrounding a periphery of the upper portion 160a of the display 160. Alternatively, one side of an upper portion of a front surface of the first housing 110 may be coupled to (or adhered to, or disposed to be adjacent to) one side of the upper portion 160a of the display 160. In this regard, an adhesive layer may be disposed at at least a portion between the first housing 110 and the upper portion 160a of the display 160. At least a portion inside the first housing 110 may be provided in a hollow form, or may be provided in a hollow form while being coupled to the first cover, so that electronic elements (e.g., a printed circuit board, at least one processor disposed on the printed circuit board, at least one memory, or a battery) that are necessary for driving the display 160 may be disposed.

According to an embodiment, ends of peripheries of the first housing 110 (e.g., ends of the remaining three peripheries except for a periphery that faces the second housing 120) may protrude from a bottom surface of a central portion of the housing by a designated height to surround at least one side periphery of the display 160. Alternatively, sidewalls, at least some of which face a periphery of the display 160, may be disposed at at least a portion of an end of a periphery of the first housing 110. The sidewalls formed at at least some of peripheries of the first housing 110 may be formed at the remaining three peripheries except for a periphery that faces the second housing 120 while having a designated height. At least a portion of a peripheral portion of the first housing 110, which faces the second housing 120, may include a recessed portion having a specific curvature such that at least a portion of the hinge housing 150 and at least a portion of the hinge structures 200a and 200b seated on the hinge housing 150 may be disposed therein. For example, the first housing 110 may include a first stepped portion 111 on which at least a portion of the first hinge structure 200a and the second hinge structure 200b is seated, at a peripheral portion that faces the second housing 120.

According to various embodiments, the second housing 120 may be disposed parallel to the first housing 110, or at least one surface thereof may be disposed to face one surface (e.g., a surface on which the display 160 is disposed) of the first housing 110, depending on a disposition thereof. The second housing 120 may be provided of the same material as that of the first housing 110. For example, at least a portion of the second housing 120 may be formed of a metallic material, and at least a remaining portion may be formed of a non-metallic material (e.g., an injection-molded product). Because the second housing 120 is disposed to be symmetrical to the first housing 110 leftward and rightward and upward and downward, it may be disposed to support at least a portion (e.g., a lower portion 160b (or a second area in the -x-axis direction) of the display 160 and an opposite side of the central portion 160c) of a remaining area of the display 160, other than the areas disposed in the first housing 110 on a front surface thereof. At least a portion of the second housing 120 may be adhered to a lower portion 160b of the display 160 (or adhered to at least a portion of a rear surface (a surface in the -z-axis direction) of the lower portion 160b of the display 160). Alternatively, a periphery of a front surface of the second housing 120 may be adhered to a periphery of a lower portion 160b of the display 160. Alternatively, one side (or at least a portion of a lower portion of a front surface of the second housing 120) of the front surface of the second housing 120 may be adhered to one side (or at least a portion of the lower portion 160b of the display 160) of the lower portion 160b of the display 160. In this regard, an adhesive layer may be disposed at at least a portion between the second housing 120 and the lower portion 160b of the display 160. At least a portion of an inside of the second housing 120 may be provided in a hollow form similarly to the first housing 110, or may be provided in a hollow form while being coupled to the second cover 120r such that an electronic element that is necessary for driving the display 160 is disposed therein.

According to various embodiments, ends of peripheries of the second housing 120 (e.g., ends of the remaining three peripheries except for a periphery that faces the first housing 110) may protrude from a bottom surface of a central portion of the second housing 120 by a designated height to surround an opposite side periphery of the display 160. Alternatively, sidewalls, at least some of which face a periphery of the display 160, similarly to the sidewalls formed in the first housing 110, may be disposed at at least a portion of an end of a peripheral end of the second housing 120. The sidewalls formed at at least some of peripheries of the second housing 120 may be formed at the remaining three peripheries except for a periphery that faces the first housing 110 while having a designated height.

At least a portion of a portion of the second housing 120, which faces the first housing 110, may include a recessed portion having a specific curvature such that the hinge housing 150 and the hinge structure 200a and 200b, at least a portion of which is seated on the hinge housing 150 may be disposed therein. For example, the second housing 120 may include a second stepped portion 121 on which at least a portion of the first hinge structure 200a and the second hinge structure 200b is seated, at a peripheral portion that faces the first housing 110.

According to an embodiment, the foldable electronic device 100 may include at least one sensor that is disposed on one side of the first housing 110 or the second housing 120, and is related to operating a specific function of the foldable electronic device 100. The sensor may include, for example, at least one of a proximity sensor, an illuminance sensor, an iris sensor, an image sensor (or a camera), or a fingerprint sensor.

According to an embodiment, different parts may be disposed in the first housing 110 and the second housing 120, respectively. As an example, a camera may be disposed only in the first housing 110, and a short-range communication antenna may be disposed only in the second housing 120.

According to an embodiment, the hinge housing 150 may be covered by one side of the first housing 110 and the second housing 120 (e.g., the unfolded state of the housings), or may be exposed to the outside (e.g., the folded state of the housings), depending on the folded state or the unfolded state of the foldable electronic device 100. For example, as illustrated in FIG. 1, when the first housing 110 and the second housing 120 are disposed in parallel (or when the housings 110 and 120 are in the unfolded state), the hinge housing 150 may be covered by the first housing 110 and the second housing 120. When one surface of the first housing 110 and one surface of the second housing 120 are disposed to face each other (or when the housings 110 and 120 are in the folded state), at least a portion of the hinge housing 150 may be disposed to be exposed to the outside at side peripheries (e.g., peripheries, at which the first housing 110 and the second housing 120 face each other in the unfolded state).

According to an embodiment, at least a portion of the display 160 may be provided to be flexible. According to an embodiment, the display 160 may include an upper portion 160a or a first area that is disposed on the first housing 110, a lower portion 160b or a second area that is disposed on the second housing 120, and a central portion 160c or a central area, in which the first housing 110 and the second housing 120 are adjacent to each other. According to an embodiment, the entire display 160 may be flexible. Alternatively, at least a portion of the central portion 160c of the display 160 may be provided to be flexible. The central portion 160c of the display 160 may be disposed such that the first housing 110 and the second housing 120 are not adhered to each other. For example, the central portion 160c of the display 160 may be disposed to be spaced apart by a specific distance from front surfaces of the first housing 110 and the second housing 120. The upper portion 160a of the display 160 may be coupled to (or adhered to, disposed to be adjacent to, or disposed to contact) at least a portion of the first housing 110, and the lower portion 160b of the display 160 may be coupled to at least a portion of the second housing 120. In this regard, an adhesive layer may be disposed in at least a partial area between the display 160 and the first housing 110, and an adhesive layer (an adhesive layer that is disposed at a different position from the adhesive layer that contacts at least a portion of the first housing 110 and the upper portion 160a of the display 160) may be disposed in at least a partial area between the display 160 and the second housing 120. The adhesive layer disposed on the first housing 110 and the adhesive layer disposed on the second housing 120 may be disposed only at peripheries of the first housing 110 and the second housing 120.

According to an embodiment, the hinge structures 200a and 200b may include a first hinge structure 200a and a second hinge structure 200b. The illustrated drawing illustrates a state in which two hinge structures, that is, the first hinge structure 200a and the second hinge structure 200b are disposed in the hinge housing 150, but the disclosure is not limited thereto, and three or more hinge structures may be disposed on the hinge housing 150 as necessary.

According to an embodiment, several hinge structures 200a and 200b may be disposed along the central portion 160c of the display 160. According to an embodiment, at least some hinge structures 200a and 200b, among several hinge structures 200a and 200b disposed along the central portion 160c of the display 160, may include different shapes/structures or different parts from those of the other hinge structures 200a and 200b.

The first hinge structure 200a may be disposed at one side of the hinge housing 150 (e.g., at a left side with respect to a longitudinal central line of the foldable electronic device illustrated in the drawing). The first hinge structure 200a may be coupled to sides of the first housing 110 and the second housing 120 (e.g., opposite sides of the first housing 110 and the second housing 120, in an area in which the first housing 110 and the second housing 120 are disposed to be adjacent to each other when the foldable electronic device is in the unfolded state), and may be rotated within a specific range with respect to a major axis of the hinge housing 150 (or at least a portion of the central portion 160c of the display 160 that is folded). The first hinge structure 200a may be disposed to be symmetrical to the second hinge structure 200b with respect to a central portion of the hinge housing 150. The first hinge structure 200a may include a gear interlocking structure to which a gradient is applied according to an embodiment of the disclosure.

The second hinge structure 200b may be disposed at an opposite side of the hinge housing 150 (e.g., at a left side with respect to a longitudinal central line of the foldable electronic device illustrated in the drawing). The second hinge structure 200b may be coupled to an opposite side of the first housing 110 (e.g., a left side with respect to a longitudinal central line of the foldable electronic device (e.g., an imaginary line that crosses a center of the display 160 while connecting the x-axis and the -x-axis)) and an opposite side of the second housing 120 (e.g., a left side with respect to the longitudinal central line of the foldable electronic device), and may be rotated within a designated range with respect to a transverse axis of the hinge housing 150. The second hinge structure 200b may be disposed to be symmetrical to the first hinge structure 200a with respect to a central portion of the hinge housing 150. The second hinge structure 200b may include the same structure and configuration as those of the first hinge structure 200a, but its disposition position may be different. The second hinge structure 200b may include a gear interlocking structure to which a gradient is applied according to an embodiment of the disclosure. Alternatively, a gear interlocking structure to which a gradient is applied according to an embodiment of the disclosure may be disposed in any one of the first hinge structure 200a or the second hinge structure 200b, or in both of the hinge structures. As an example, when the foldable electronic device includes three or more hinge structures, all three hinge structures may include a gear interlocking structure to which a gradient is applied, or a gear interlocking structure to which a gradient is applied may be disposed only in hinge structures (or two hinge structures) that are disposed at peripheries on both sides of a line (or a folding axis) along which the display is folded, or a gear interlocking structure to which a gradient is applied may be disposed in at least one hinge structure other than the hinge structures that are disposed at the peripheries on both sides.

According to an embodiment, according to the foldable electronic device 100, the wing plates 131 and 132 are disposed to be positioned on at least one hinge structure 200a or 200b, or coupled to at least one hinge structure 200a or 200b, to cover at least one surface of the at least one hinge structure 200a or 200b in the z-axis direction when the foldable electronic device 100 is in the unfolded state. The wing plates 131 and 132 may be provided in a form in which they are separated from the housings 110 and 120. Accordingly, a gap may be formed between the wing plates 131 and 132 and the housings 110 and 120. According to an embodiment, grooves in which the wing plates 131 and 132 may be seated are provided in the housings 110 and 120. The wing plates 131 and 132 may be disposed to correspond to at least a portion of a lower surface (e.g., a surface in the -z-axis direction) of a third area 160c (or a central portion) of the display 160. The wing plates 131 and 132 may be rotated clockwise or counterclockwise in response to a hinge operation of at least one hinge structure 200a or 200b. For example, a second wing plate 132 may be rotated clockwise while a first wing plate 131 is rotated counterclockwise, and the second wing plate 132 may be rotated counterclockwise while the first wing plate 131 is rotated clockwise. The first wing plate 131 may support a flat first surface of the third area 160c of the display 160, which is folded in a dumbbell shape (or a water droplet shape), and the second wing plate 132 may support a flat second surface (a surface that is symmetrical to the first surface with respect to the z-axis) of the third area 160c of the display 160, which is folded in a dumbbell shape.

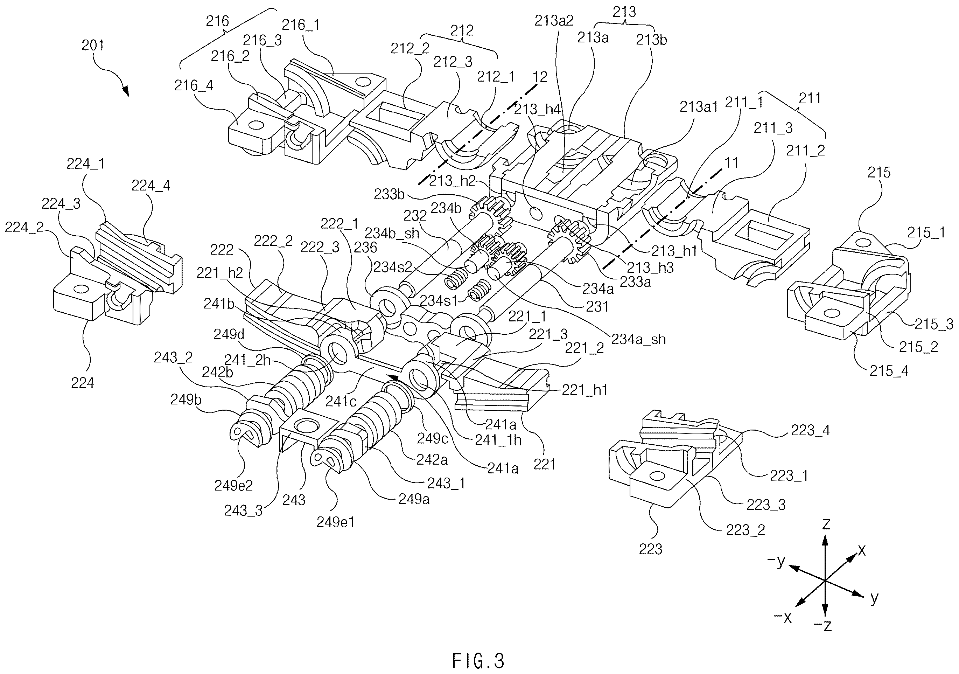

FIG. 3 is a view illustrating an example of an exploded perspective view of a hinge structure according to an embodiment. The hinge structure 201 illustrated in FIG. 3 may correspond to any one of the first hinge structure 200a or the second hinge structure 200b described above with reference to FIG. 2, or to both of them.

Referring to FIGS. 1 to 3, the hinge structure 201 may include a fixing bracket 213 including a lower fixing bracket 213a (e.g., including a first rail 213a1 and a second rail 213a2) and an upper fixing bracket 213b, a first rotary member 211 (or a first rotary structure, a first rotational part, or a first rotary body) (e.g., a member including a first rotational body 211_3, a first rail structure 211_1, and a second rail structure 211_2) that is rotated around a first axis 11 (e.g., an imaginary axis in the y-axis direction that is different from a first shaft 231), a second rotary member 212 (or a second rotary structure, a second rotational part, or a second rotary body) (e.g. a member including a second rotational body 212_3, a third rail structure 212_1, and a fourth rail structure 212_2) that is rotated around a second axis 12 (or a second imaginary axis that is different from a second shaft 232 and formed in parallel to the first axis 11), a first arm member 221 (or a first arm part, a first arm structure, or a first arm) (e.g., including a first arm body 221_3, a first arm part 221_1, and a second arm part 221_2) that is rotated about a center (or a first central axis of the shaft, or a third axis) of the first shaft 231, a second arm member 222 (or a second arm part, a second arm structure, or a second arm) (e.g., including a second arm body 222_3, a third arm part 222_1, and a fourth arm part 222_2) that is rotated about a center (or a second central axis of the second shaft, or a fourth axis) of the second shaft 232, a first link member 215 (e.g., including a first link body 215_3, an eleventh link sidewall 215_1, a twelfth link sidewall 215_2, and a first link connector 215_4) configured that supports rotation (or sliding) of the first rotary member 211 while fixing the first rotary member 211 to the first housing 110 of FIG. 2, a second link member 216 (e.g., including a second link body 216_3, a twenty-first link sidewall 216_1, a twenty-second link sidewall 216_2, and a second link connector 216_4) that supports rotation (or sliding) of the second rotary member 212 while fixing the second rotary member 212 to the second housing 120 of FIG. 2, a third link member 223 (e.g., including a third link body 223_3, a thirty-first link sidewall 223_1, a thirty-second link sidewall 223_2, and a third link connector 223_4) that supports rotation (or sliding) of the first arm member 221 while fixing the first arm member 221 to the first housing 110 of FIG. 2, and a fourth link member 224 (e.g., including a fourth link body 224_3, a forty-first link sidewall 224_1, a forty-second link sidewall 224_2, and a fourth link connector 224_4) that supports rotation (or sliding) of the second arm member 222 while fixing the second arm member 222 to the second housing 120 of FIG. 2.

At least some (e.g., at least some of the first to fourth link members 215, 216, 223, and 224) of the components of the above-described hinge structure 201 may be omitted. For example, the first rotary member 211 and the second rotary member 212 are directly coupled to the housings 110 and 120 of FIG. 2, and the arm members 221 and 222 may be rotated in response to the rotation of the rotary members 211 and 212 while being coupled to the rotary members 211 and 212. According to an embodiment, at least some of the first to fourth link members 215, 216, 223, and 224 may be integrated. As an example, the first link member 215 and the third link member 223 may be integrated, and the second link member 216 and the fourth link member 224 may be integrated. Alternatively, at least some of the first to fourth link members 215, 216, 223, and 224 may be integrated with the housing.

A hinge structure according to an embodiment of the disclosure may include a first main gear 233a (or a first gear or a first shaft gear) that is formed (disposed) in the first shaft 231, a second main gear 233b (or a second gear or a second shaft gear) that is formed (disposed) in the second shaft 232, at least one interlocking gear 234a or 234b (or an idle gear) that is disposed between the first main gear 233a and the second main gear 233b, at least one gear elastic body 234s1 and 234s1 (or a first elastic body and a second elastic body or a first elastic member and a second elastic member) that pushes the at least one interlocking gear 234a and 234b in the x-axis direction (or a direction that is parallel to a folding axis, along which the display 160 of FIG. 2 is folded), a stopper 236 (or an arm support structure or a shaft support structure) that is used to fix the first main gear 233a and the second main gear 233b, and at least one interlocking gear 234a or 234b, and prevents the first arm member 221 and the second arm member 222 from being rotated by a specific angle or more, a shaft fixing part 243 that is used to fix the first shaft 231 and the second shaft 232, a cam member 241 that is cam-coupled to the cam structures formed in the first arm member 221 and the second arm member 222, a first cam elastic body 242a (or a third elastic body or a third elastic member) and a second cam elastic body 242b (or a fourth elastic body or a fourth elastic member) that provide an elastic force to the cam member 241, a plurality of coupling members 249e1 and 249e2, and washer rings 249a and 249b. The gear teeth of at least one of the first main gear 233a, the second main gear 233b, the first interlocking gear 234a, and the second interlocking gear 234b, among the above-described components, may have a gradient formed.

According to an embodiment, at least a portion of the fixing bracket 213 having a shape of a lower surface (e.g., a surface in the -z-axis direction) may include a curved surface. For example, at least a portion of a lower surface of the fixing bracket 213 may be formed to correspond to an inner shape of the hinge housing 150 of FIG. 2. At least a portion of an upper surface (e.g., a surface in the z-axis direction) of the fixing bracket 213 may include a lower fixing bracket 213a that is provided in a flat shape and in which rails 213a2 and 213a1 are formed such that rotary members 211 and 212 may be coupled thereto, and an upper fixing bracket 213b that covers an upper portion of the lower fixing bracket 213a. According to an embodiment, at least a portion of a cross-section of the fixing bracket 213 from an upper surface (e.g., a surface in the z-axis direction) toward a lower surface (e.g., a surface in the -z-axis direction) may include an arc shape. The lower fixing bracket 213a may include a first rail 213a1, into which the first rail structure 211_1 of the first rotary member 211 having the first rail structure 211_1 and the second rail structure 211_2 is inserted from one direction (e.g., the -x-axis direction) to an opposite direction (e.g., the x-axis direction), and a second rail 213a2, into which the third rail structure 212_1 of the second rotary member 212 having the third rail structure 212_1 and the fourth rail structure 212_2 is inserted from the opposite direction (e.g., the x-axis direction) to the one direction (e.g., the -x-axis direction). With respect to the first axis 11 or the second axis 12 (or with respect to the x-axis that passes through a center between the first rotary member 211 and the second rotary member 212), the first rail 213a1 may be disposed to be offset in the -x-axis direction compared to the second rail 213a2, and the second rail 213a2 may be disposed to be offset in the x-axis direction compared to the first rail 213a1. The first rail structure 211_1 of the first rotary member 211 that is inserted into the first rail 213a1 may be rotated around the first axis 11, and the third rail structure 212_1 of the second rotary member 212 that is inserted into the second rail 213a2 may be rotated around the second axis 12. The first axis 11 and the second axis 12 may be formed above (air) an upper surface (e.g., a surface in the z-axis direction) of the fixing bracket 213. Alternatively, the first axis 11 and the second axis 12 may be formed between an upper surface of the display 160 of FIG. 2 and a lower surface (e.g., a surface in the -z-axis direction) of the upper fixing bracket 213b.

According to an embodiment, one side (e.g., a side surface that faces the -x-axis direction) of the fixing bracket 213 may include a first recess 213_h1 (or a first hole or a first opening), into which one side (e.g., a periphery of an end in the x-axis direction) of the first shaft 231 on which the first main gear 233a is formed (or disposed) may be inserted, and a second recess 213_h2 (or a second hole or a second opening), into which one side (e.g., a periphery of an end in the x-axis direction) of the second shaft 232 on which the second main gear 233b is formed (or disposed) may be inserted. According to an embodiment, one side (e.g., a side surface that faces the -x-axis direction) of the fixing bracket 213 may include a third recess 213_h3 (or a third hole or a third opening), into which one side (e.g., a periphery of an end in the x-axis direction) of a third shaft 234a_sh formed at a central portion of the first interlocking gear 234a may be inserted, and a fourth recess 213_h4 (or a fourth hole or a fourth opening), into which one side (e.g., a periphery of an end in the x-axis direction) of a fourth shaft 234b_sh formed at a central portion of the second interlocking gear 234b may be inserted. The third recess 213_h3 and the fourth recess 213_h4 may be disposed between the first recess 213_h1 and the second recess 213_h2. Diameters (or cross-sectional sizes in the z-axis direction) of the third recess 213_h3 and the fourth recess 213_h4 may be formed to be smaller than diameters (or cross-sectional sizes in the z-axis direction) of the first recess 213_h1 and the second recess 213_h2. At least a portion of the first gear elastic body 234s1 may be inserted into the third shaft 234a_sh, and at least a portion of the second gear elastic body 234s2 may be inserted into the fourth shaft 234b_sh.

According to an embodiment, a modulus (e.g., a shear elastic modulus) of at least one of the gear elastic bodies 234s1 and 234s2 may have a value (e.g., about 7000 kgf/mm) between 5000 kgf/mm and 9000 kgf/mm in consideration of a pressure generated in a process of folding or unfolding the foldable electronic device 100. For example, the modulus may be selected in consideration of a force by which the first interlocking gear 234a is pushed toward the stopper 236 due to a tolerance or twisting of gear teeth while the first main gear 233a and the first interlocking gear 234a are engaged with each other and rotated. The above-described modulus value may vary depending on a size change of the foldable electronic device 100 or a change in the number and shapes of other elastic bodies.

According to an embodiment, a maximum allowable stress of at least one of the gear elastic bodies 234s1 and 234s2 may have a value (e.g., about 100 kgf/mm²) between 50 kgf/mm² and 150 kgf/mm² in consideration of a pressure required in a process of folding or unfolding the foldable electronic device 100.

According to an embodiment, the first axis 11 and the second axis 12 may be spaced apart from each other by a specific interval. According to an embodiment, an interval between the first axis 11 and the second axis 12 may be formed to be smaller than an interval between the first shaft 231 and the second shaft 232. According to an embodiment, the first axis 11 and the second axis 12 may be formed above the first shaft 231 and the second shaft 232 with respect to the z-axis. Alternatively, the first axis 11 and the second axis 12 may be formed closer to an upper surface of the display 160 of FIG. 2 than the first shaft 231 and the second shaft 232 with respect to the z-axis. According to an embodiment, the lower fixing bracket 213a may include at least one fixing hole that is used to fix the fixing bracket 213 to the hinge housing 150 of FIG. 2. The upper fixing bracket 213b may be fixed to the lower fixing bracket 213a through at least one coupling member. The foldable electronic device 100 may fix the fixing bracket 213 to the hinge housing 150 of FIG. 2 by using a coupling member (e.g., a screw, a rivet, or welding).

Main holding recesses on which a one-side end (e.g., an end in the y-axis direction) of the first shaft 231 and a one-side end (e.g., an end in the y-axis direction) of the second shaft 232 are held may be formed on a sidewall of the lower fixing bracket 213a in the -y-axis direction. According to an embodiment, idle holding recesses in which one side (e.g., idle shafts formed at centers of the interlocking gears 234a and 234b) of at least one of the interlocking gears 234a and 234b may be held may be formed between the main holding recesses of a sidewall of the lower fixing bracket 213a in the -y-axis direction.

The upper fixing bracket 213b may be disposed between the lower fixing bracket 213a and the rotational members 231 and 232, and may be disposed to prevent separation of the rotational members 231 and 232 and the interlocking gears 233 and 234. In this regard, the upper fixing bracket 213b may include a plurality of guide holes. For example, the upper fixing bracket 213b may include a guide hole, through which one end of the first rail structure 211_1 of the first shaft 231 passes, and guide holes, through which one end of the third rail structure 212_1 of the second shaft 232 passes.

According to an embodiment, the first rotary member 211 may include a first rotational body 211_3, a first rail structure 211_1 that extends to a one-side end (e.g., an end in the x-axis direction) of the first rotational body 211_3, and a second rail structure 211_2 that extends to an opposite end (e.g., an end in the -x-axis direction) of the first rotational body 211_3. The first rotational body 211_3 may be disposed between the first rail structure 211_1 and the second rail structure 211_2 having a rail shape. At least a portion of the first rotational body 211_3 may be fastened to one side of the lower fixing bracket 213a. The first rail structure 211_1 and the second rail structure 211_2 may be formed to be stepped with respect to the first rotational body 211_3. The first rail structure 211_1 of the first rotary member 211 may be fastened to one side of the fixing bracket 213 (e.g., the first rail 213a1) to be hinge-movable. The second rail structure 211_2 of the first rotary member 211 may be coupled to one side of the first link member 215 to perform sliding (or rotation or arc motion) in response to a hinge operation (or rotation or sliding) of the first rail structure 211_1. While the first link member 215 coupled to the first housing 110 of FIG. 2 is moved in response to the movement of the first housing 110, the first rail structure 211_1 of the first rotary member 211, which is fastened to the fixing bracket 213, may be rotated in place around the first axis 11. As an example, the second rail structure 211_2 of the first rotary member 211 may be rotated (or slid) in the first link member 215 while being moved in one direction (e.g., counterclockwise while the foldable electronic device 100 is folded from the unfolded state or clockwise while the foldable electronic device 100 is unfolded from the folded state). At least a portion of the first wing plate 131, among the wing plates 131 and 132 of FIG. 2, may be fixed to the first rotary member 211. As an example, when the hinge structure 201 is a first hinge structure 200a of FIG. 2, the first rotary member 211 may be coupled to the first wing plate 131 of FIG. 2, and when the hinge structure 201 is a second hinge structure 200b of FIG. 2, the first rotary member 211 may be coupled to the second wing plate 132 of FIG. 2. In this regard, the first rotational body 211_3 may include at least one hole or recess that is to be coupled to the first wing plate 131 of FIG. 2.

According to an embodiment, the second rotary member 212 may include a part (e.g., a third rail structure 212_1) that is fastened to the opposite side (e.g., a second rail 213a2) of the fixing bracket 213 and then coupled to be hinged, a part (e.g., a fourth rail structure 212_2) that is coupled to the second link member 222, and a second rotational body 212_3 that is disposed between the third rail structure 212_1 and the fourth rail structure 212_2. The third rail structure 212_1 and the fourth rail structure 212_2 may be formed to be stepped with respect to the second rotational body 212_3. While the second link member 222 coupled to the second housing 120 of FIG. 2 is moved in response to the movement of the second housing 120, the third rail structure 212_1 of the second rotary member 212, which is fastened to the fixing bracket 213, may be rotated in place around the second axis 12. The fourth rail structure 212_2 that is coupled to the second link member 222 may be rotated (or slid) in the second link member 222 while being moved in one direction (e.g., counterclockwise while the foldable electronic device 100 is folded from the unfolded state or clockwise while the foldable electronic device 100 is unfolded from the folded state). The third rail structure 212_1 may include a rail structure that is similar to or the same as the first rail structure 211_1. The fourth rail structure 212_2 that is coupled to the second link member 222 may be rotated (or slid) in the second link member 222 while being moved in one direction (e.g., counterclockwise while the foldable electronic device 100 is folded from the unfolded state or clockwise while the foldable electronic device 100 is unfolded from the folded state). In this regard, the second link member 222 may include rail wings, in which an empty space is formed at a central portion thereof similar to the first link member 215, and including curved surfaces disposed on opposite sides thereof.

According to an embodiment, the second rotary member 212 may generate friction with the fixing bracket 213 and the second link member 222 while hinge operations are repeatedly performed similar to the first rotary member 211, and may be formed of a material (e.g., a metal material) having a specific strength or more that may withstand the friction. For example, the second rotary member 212 may be formed of the same material as that of the first rotary member 211. At least a portion of the second wing plate 132, among the wing plates 131 and 132 of FIG. 2, may be fixed to the second rotary member 212. As an example, when the hinge structure 201 is a first hinge structure 200a of FIG. 2, the second rotary member 212 may be coupled to the second wing plate 132 of FIG. 2, and when the hinge structure 201 is a second hinge structure 200b of FIG. 2, the second rotary member 212 may be coupled to the first wing plate 132 of FIG. 2. In this regard, the second rotational body 212_3 may include at least one hole or recess that is to be coupled to the second wing plate 132 of FIG. 2. The second rotary member 212 may be moved in an opposite direction to the first rotary member 211. For example, while the first rail structure 211_1 of the first rotary member 211 is rotated in place counterclockwise, the third rail structure 212_1 of the second rotary member 212 may be rotated in place clockwise.

According to an embodiment, while the foldable electronic device 100 is folded, the first rail structure 211_1 of the first rotary member 211 may be rotated counterclockwise, and the first link member 215 inserted into the second rail structure 211_2 may be relatively slid clockwise along the second rail structure 211_2, and thus, the first link member 215 may be slid clockwise with respect to the second rail structure 211_2 (the sliding is relative, and the first link member 215 may be slid clockwise with respect to the second rail structure 211_2). While the foldable electronic device 100 is folded, the third rail structure 212_1 of the second rotary member 212 may be rotated clockwise along the second rail 213a2 of the fixing bracket 213, and the second link member 222 inserted into the fourth rail structure 212_2 may be relatively slid counterclockwise, and thus, the second link member 222 may be slid clockwise with respect to the fourth rail structure 212_2 (the sliding is relative, and the second link member 222 may be slid clockwise with respect to the fourth rail structure 212_2).

According to an embodiment, the first link member 215 may include a structure that is coupled and fixed to one side of the first housing 110 of FIG. 2. The first link member 215 may include an eleventh link sidewall 215_1 (or a first sidewall of the first link member 215) and a twelfth link sidewall 215_2 (or a second sidewall of the first link member 215) that extend from opposite surfaces (e.g., the x-axis and -x-axis peripheries) of the first link body 215_3 in the z-axis direction, and a first link connector 215_4 that connects the first link body 215_3 to the third link member 223. The first link member 215 may include a structure (e.g., an eleventh link sidewall 215_1 and a twelfth link sidewall 215_2), on which a portion of the first rotary member 211 (e.g., a second rail structure 211_2) is seated. A rail wing that protrudes toward the twelfth link sidewall 215_2 may be formed in the eleventh link sidewall 215_1, and a rail wing that protrudes toward the eleventh link sidewall 215_1 may be formed in the twelfth link sidewall 215_2. The rail wings may be fastened to the second rail structure 211_2. At least one structure (e.g., a hole or a recess) that is used to fix the first link member 215 to the first housing 110 of FIG. 2 may be formed in at least one of the eleventh link sidewall 215_1 and the twelfth link sidewall 215_2. The first link member 215 may be disposed in parallel to the third link member 223 in the y-axis direction. The first link connector 215_4 may protrude from the twelfth link sidewall 215_2 toward the third link member 223.

According to an embodiment, the second link member 216 may include a structure that is coupled and fixed to one side of the second housing 120 of FIG. 2. The second link member 216 may include a twenty-first link sidewall 216_1 and a twenty-second link sidewall 216_2 that extend from opposite sides (e.g., the y-axis and -y-axis peripheries) of the second link body 216_3 in the z-axis direction, and a second link connector 216_4 that is used to connect the second link member 216 to the fourth link member 224. The second link member 216 may include structures (e.g., a twenty-first link sidewall 216_1 and a twenty-second link sidewall 216_2), on which a portion (e.g., a fourth rail structure 212_2) of the second rotary member 212 is seated. A rail wing that protrudes toward the twenty-second link sidewall 216_2 may be formed in the twenty-first link sidewall 216_1, and a rail wing that protrudes toward the twenty-first link sidewall 216_1 may be formed in the twenty-second link sidewall 216_2. The rail wings may be fastened to the fourth rail structure 212_2. At least one structure (e.g., a hole or a recess) that is used to fix the second link member 216 to the second housing 120 of FIG. 2 may be formed in the twenty-first link sidewall 216_1 and the twenty-second link sidewall 216_2. The above-described second link member 216 may be disposed to be symmetrical to the first link member 215 with respect to the y-axis direction. The second link member 216 may be disposed in parallel to the fourth link member 224 in the y-axis direction. The second link connector 216_4 may protrude from the twenty-second link sidewall 216_2 toward the fourth link member 224.

According to an embodiment, the third link member 223 may include a structure, on which a portion of the first arm member 221 is seated. The third link member 223 may include a third link body 223_3, and a thirty-first link sidewall 223_1 and a thirty-second link sidewall 223_2 that extend from opposite sides (e.g., the y-axis and -y-axis peripheries) of the third link body 223_3 in the -z-axis direction. A rail wing that protrudes toward the thirty-second link sidewall 223_2 may be formed in the thirty-first link sidewall 223_1, and a rail wing that protrudes toward the thirty-first link sidewall 223_1 may be formed in the thirty-second link sidewall 223_2. The rail wings may be fastened to one side (e.g., a rail groove formed in the y-axis direction) and an opposite side (e.g., a rail groove formed in the -y-axis direction) of the second arm part 221_2 of the first arm member 221 including a first arm part 221_1 and the second arm part 221_2, respectively. A structure (e.g., at least one hole or recess) that is used to fix the third link member 223 to the first housing 110 of FIG. 2 may be formed in the thirty-first link sidewall 223_1 and the thirty-second link sidewall 223_2. An empty space may be formed between the thirty-first link sidewall 223_1 and the thirty-second link sidewall 223_2, and a second arm part 221_2 of the first arm member 221 may be seated in the empty space so that sliding of the second arm part 221_2 may be guided. The third link member 223 may include a third link connector 223_4 that protrudes from one side (e.g., the thirty-first link sidewall 223_1) of the third link body 223_3 in the x-axis direction. In a process of fixing the first link member 215 and the third link member 223 to the first housing 110 of FIG. 2, the third link connector 223_4 may be formed to overlap the first link connector 215_4 of the first link member 215.

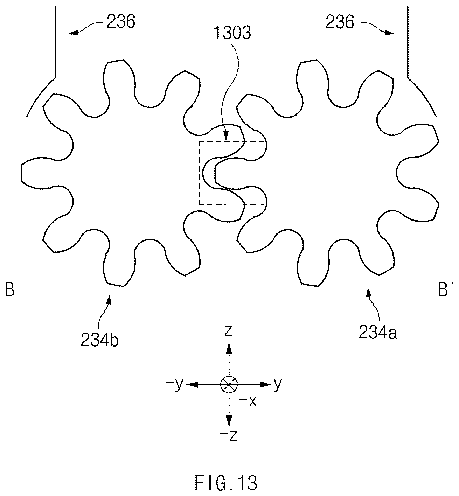

According to an embodiment, the fourth link member 224 may include a structure, on which a portion of the second arm member 222 is seated. In this regard, the fourth link member 224 may include a fourth link body (e.g., a link body that is disposed at a position that is symmetrical to the third link body 223_3 with respect to the y-axis while having the same shape, and 224_3 in FIG. 13 to be described below), a forty-first link sidewall 224_1 and a forty-second link sidewall 224_2 that extend from opposite sides (e.g., the y-axis and -y-axis peripheries) of the fourth link body 224_3 in the -z-axis direction, and a fourth link connector. A rail wing that protrudes toward the forty-second link sidewall 224_2 may be formed in the forty-first link sidewall 224_1, and a rail wing that protrudes toward the forty-first link sidewall 224_1 may be formed in the forty-second link sidewall 224_2. The rail wings may be fastened to one side (e.g., a rail groove of the fourth arm part 222_2 in the y-axis direction) and an opposite side (e.g., a rail groove of the fourth arm part 222_2 in the -y-axis direction) of the fourth arm part 222_2 of the second arm member 222 including a third arm part 222_1 and the fourth arm part 222_2. A structure (e.g., at least one hole or recess) that is used to fix the fourth link member 224 to the second housing 120 of FIG. 2 may be formed in the forty-first link sidewall 224_1 and the forty-second link sidewall 224_2. An empty space may be formed between the forty-first link sidewall 224_1 and the forty-second link sidewall 224_2, and the empty space may be used to guide the fourth arm part 222_2 while one side (e.g., the fourth arm part 222_2) of the second arm member 222 is slid. The fourth link member 224 may include a fourth link connector 224_4 that protrudes from one side (e.g., the forty-first link sidewall 224_1) of the fourth link body in the x-axis direction. In a process of fixing the second link member 216 and the fourth link member 224 to the second housing 120 of FIG. 2, the fourth link connector 224_4 may be formed to overlap the second link connector 216_4 of the second link member 216.

At least one of the first to fourth link members 215, 216, 223, and 224 may be formed of the same material. Alternatively, they may be formed at least partially of different structures (e.g., an injection-molded product). Meanwhile, a form, in which the link members 215, 216, 223, and 224 are separated, has been illustrated in the above description, but the disclosure is not limited thereto. For example, the first link member 215 and the third link member 223 may be connected to or integrated with each other, and the second link member 216 and the fourth link member 224 may be connected to or integrated with each other.

According to an embodiment, the first arm member 221 may be disposed to be symmetrical to the second arm member 222 with respect to the x-axis or the -x-axis (or the x-axis). Accordingly, among structures of the first arm member 221 described below, parts that are difficult to observe in the illustrated drawings will be described based on structures of the second arm member 222. The first arm member 221 may be rotated from the z-axis in the -x-axis direction or from the -x-axis direction in the z-axis direction. Alternatively, the first arm member 221 may be rotated in a counterclockwise direction (e.g., a direction, in which the foldable electronic device 100 is operated from an unfolded state to a folded state) or a clockwise direction (e.g., a direction, in which the foldable electronic device 100 is operated from a folded state to an unfolded state) with respect to the x-axis direction. The first arm member 221 may include a first arm body 221_3, a first arm part 221_1, and a second arm part 221_2. The first arm body 221_3 may be disposed between the first arm part 221_1 and the second arm part 221_2. The first arm part 221_1 includes a first through-hole 221_h1 that is formed to extend from the first arm body 221_3 in the x-axis direction, and through which a first shaft 231 may pass, and a first cam structure that performs a cam operation while contacting one side (e.g., a cam portion disposed in the -x-axis direction) of the cam member 241 may be provided at a peripheral structure that forms the first through-hole 221_h1. The first through-hole 221_h1 may have a partially crushed shape or a D-shape at a portion of a z-axis cross-section so that it may be rotated in response to rotation of the first shaft 231. The first cam structure of the first arm part 221_1 may be formed on a surface (e.g., a surface of the first arm member 221 in the -y-axis direction, or a central direction of the hinge housing 150 of FIG. 2) that faces the cam member 241. When the foldable electronic device 100 is to be rotated by a predetermined angle or more, the first arm part 221_1 that faces the stopper 236 may include a hook or a step that is provided to be stopped by one side (e.g., a stopper portion of an area disposed in the first main gear 233a) of the stopper 236. The first arm part 221_1 seated on the first shaft 231 may be disposed between the stopper 236 and one side of the cam member 241. The second arm part 221_2 may be formed to extend from the first arm body 221_3 in the -x-axis direction. The second arm part 221_2 may be fastened to the third link member 223, and may perform sliding along rail wings formed in the third link member 223 while the foldable electronic device 100 performs a hinge operation. In this regard, the second arm part 221_2 may include rail grooves that may be fastened to rail wings formed in the third link member 223.

According to an embodiment, the second arm member 222 may be disposed to be symmetrical to the first arm member 221 with respect to the y-axis or the -y-axis. The second arm member 222 may be rotated from the z-axis in the x-axis direction or from the x-axis direction in the z-axis direction. The second arm member 222 may be rotated in a direction that is opposite to a motion direction of the first arm member 221. The second arm member 222 may include a second arm body 222_3, a third arm part 222_1, and a fourth arm part 222_2. The second arm body 222_3 may be disposed between the third arm part 222_1 and the fourth arm part 222_2. The third arm part 222_1 includes a second through-hole 221_h2 that is formed to extend from the second arm body 222_3 in the -x-axis direction, and through which a second shaft 232 may pass, and a second cam structure that performs a cam operation while contacting an opposite side (e.g., a cam portion disposed in the x-axis direction) of the cam member 241 may be provided at a peripheral structure that forms the second through-hole 221_h2. The second through-hole 221_h2, similar or identical to the structure of the first through-hole 221_h1, may have a partially crushed shape or a D-shape at a portion of a z-axis cross-section so that it may be rotated in response to rotation of the second shaft 232. The second cam structure of the third arm part 222_1 may be formed on a surface (e.g., a surface of the second arm member 222 in the -y-axis direction, or a central direction of the hinge housing 150 of FIG. 2) that faces the cam member 241. The third arm part 222_1 that faces the stopper 236 may include a protruding hook or step that is provided to be stopped by an opposite side (e.g., a stopper portion of an area disposed in the second main gear 233b) of the stopper 236. A step of the third arm part 222_1 may be supported by the stopper 236 so that the foldable electronic device 100 is not folded by a specific angle or more when an external pressure is applied at not less than an angle (e.g., more than 180 degrees), by which the foldable electronic device 100 is unfolded. The third arm part 222_1 seated on the second shaft 232 may be disposed between the stopper 236 and one side of the cam member 241. The fourth arm part 222_2 may be formed to extend from the second arm body 222_3 in the x-axis direction. The fourth arm part 222_2 may be fastened to the fourth link member 224, and may perform sliding along rail wings formed in the fourth link member 224 while the foldable electronic device 100 performs a hinge operation. In this regard, the fourth arm part 222_2 may include rail grooves that may be fastened to rail wings formed in the fourth link member 224.

According to various embodiments, the rail structures (or arc-shaped rail structures) formed in the first rotary member 211, the second rotary member 212, the first arm member 221 and the second arm member 222, the first to fourth link members 215, 216, 223, and 224, and the fixing bracket 213 may be formed in a shape of any one of a rail groove or a rail protrusion, and other components coupled thereto may have a shape of a rail protrusion or a rail groove. As an example, the second rail structure 211_2 of the first rotary member 211 has a form of a rail groove, but may be changed to a form of a rail protrusion, and correspondingly, the first link member 215 has a structure of a rail protrusion that may be inserted into the rail groove of the second rail structure 211_2, and when the first rotary member 211 is changed to a rail protrusion, it may be changed to a form of a rail groove correspondingly. Similarly, sides of the rail structure between the second rotary member 212 and the second link member 216, between the first arm member 221 and the third link member 223, and between the second arm member 222 and the fourth link member 224 have a groove or protrusion structure so that they may be engaged with each other, and the other ones may be designed to have a protrusion or groove structure.

According to an embodiment, the first shaft 231 may have a rod shape, in which a length thereof in the y-axis or -y-axis direction is greater than a length thereof in the x-axis or z-axis direction. The first shaft 231 may be formed of a metallic material to support inserted components. The first main gear 233a may be coupled to or formed in a one-side end of the first shaft 231 (e.g., integrated with the first shaft 231). A z-axis cross-section of the first shaft 231 may include a flat area and a curved surface. As an example, an upper surface and a lower surface of a z-axis cross-section of the first shaft 231 may be formed flat, respectively, and opposite side surfaces thereof may include a curved surface. Alternatively, a z-axis cross-section of the first shaft 231 may have a polygonal shape (e.g., a triangle, a quadrangle, a pentagon, a hexagon, ...). Accordingly, a structure in which a through-hole has a cylindrical shape may be maintained in a current state while not being rotated when the first shaft 231 is rotated, and in the case of a structure in which the through-hole includes an angled shape similar to the first shaft 231, it may be rotated together while the first shaft 231 is rotated. For example, a first arm part 221_1 of the first arm member 221, a first fixed cam portion 241a of the cam member 241, at least one washer ring (e.g., a first washer ring 249a and a third washer ring 249c), a first cam elastic body 242a, a first fixed portion 243_1 of the shaft fixing part 243, and a first coupling member 249e1 (e.g., a first E-ring) may be inserted into the first shaft 231.

According to an embodiment, the second shaft 232 may have a shape that is the same as or similar to that of the first shaft 231. For example, the second shaft 232 may have a rod shape, in which a length thereof in the y-axis or -y-axis direction is greater than a length thereof in the x-axis or z-axis direction. The second shaft 232 may be formed of a metallic material having a strength that is greater than or equal to a specified magnitude to support the inserted components. The second main gear 233b may be coupled to or formed in a one-side end of the second shaft 232 (e.g., integrated with the second shaft 232). As an example, an upper surface and a lower surface of a z-axis cross-section of the second shaft 232 may be formed flat, respectively, and opposite side surfaces thereof may include a curved surface. Alternatively, a z-axis cross-section of the second shaft 232 may have a polygonal shape. Accordingly, a structure in which a through-hole has a cylindrical shape may be maintained in a current state while not being rotated when the second shaft 232 is rotated, and in the case of a structure in which the through-hole includes an angled shape similar to the second shaft 232, it may be rotated together while the second shaft 232 is rotated. For example, a third arm part 222_1 of the second arm member 222, a second fixed cam portion 241b of the cam member 241, at least one washer ring (e.g., a second washer ring 249b and a fourth washer ring 249d), a second cam elastic body 242b, a second fixed portion 243_2 of the shaft fixing part 243, and a second coupling member 249e2 (e.g., a second E-ring) may be inserted into the second shaft 232.

The cam member 241 may include a cam body 241c, a first fixed cam portion 241a, and a second fixed cam portion 241b. Additionally or alternatively, the cam member 241 may include a first cam hole 241_1h that passes in the y-axis or -y-axis direction, on which at least a portion of the first shaft 231 is held after the first shaft 231 is inserted, and that is formed at a central portion of the first fixed cam portion 241a, and a second cam hole 241_2h that passes in the y-axis or -y-axis direction, on which at least a portion of the second shaft 232 is held after the second shaft 232 is inserted, and that is formed at a central portion of the second fixed cam portion 241b. The cam body 241 c may have a specific length, and the first fixed cam portion 241a and the second fixed cam portion 241b may be disposed at opposite-side peripheries thereof. A one-directional surface (e.g., a surface in the y-axis direction) of the cam body 241c may be disposed to face a one-directional surface (e.g., a surface in the -y-axis direction) of the stopper 236.

The first fixed cam portion 241a may be disposed at an x-axis periphery from a center of the cam body 241c. The first fixed cam portion 241a may have a cylindrical shape that surrounds the first cam hole 241_1h formed to pass through a center thereof in the y-axis or -y-axis direction as a whole. The first fixed cam portion 241a may include a pattern in which mountains and valleys are repeatedly disposed to be engaged with a cam structure formed in the first arm part 221_1 of the first arm member 221. A central portion of the first cam hole 241_1h may have a specific shape such that the first shaft 231 may pass therethrough. For example, the central portion of the first cam hole 241_1h may have a circular shape. The second fixed cam portion 241b may be disposed at a -x-axis periphery (or a position that is opposite to or symmetrical to a position at which the first fixed cam portion 241a is formed while the cam body 241c is a center thereof), from a center of the cam body 241c. The second fixed cam portion 241b may have a cylindrical shape that surrounds the second cam hole 241_2h formed to pass through a center thereof in the y-axis or -y-axis direction as a whole. The second cam hole 241_2h may be formed in parallel to the first cam hole 241_1h. The second fixed cam portion 241b may include a pattern of mountains and valleys that are repeatedly disposed to be engaged with a cam structure formed in the third arm part 222_1 of the second arm member 222. A central portion of the second cam hole 241_2h may have a specific shape such that the second shaft 232 may pass therethrough. For example, the central portion of the second cam hole 241_2h may have a circular shape similar to the first cam hole 241_1h.

According to an embodiment, the cam member 241 may be retracted in one direction (e.g., the -y-axis direction) in response to a cam operation of a cam structure of the first arm member 221 and a cam structure of the second arm member 222 while the first arm member 221 and the second arm member 222 are rotated within a specific angle range, and may be moved in an opposite direction (e.g., the y-axis direction) to the one direction by elasticity of the first cam elastic body 242a (or the third elastic member) and the second cam elastic body 242b (or the fourth elastic member) when the mountains and the valleys of the cams (e.g., the cam structure and the cam portions) are engaged with each other, to return to an original position.

According to an embodiment, the hinge structure 201 may include a plurality of ring structures (e.g., a first washer ring 249a, a second washer ring 249b, a third washer ring 249c, and a fourth washer ring 249d). A one-side end (e.g., an end in the -y-axis direction) of the first shaft 231 may be inserted into the first washer ring 249a, and the first washer ring 249a may be disposed between the shaft fixing part 243 and the first coupling member 249e1. A one-side end (e.g., an end in the -y-axis direction) of the second shaft 232 may be inserted into the second washer ring 249b, and the second washer ring 249b may be disposed between the shaft fixing part 243 and the second coupling member 249e2. The first washer ring 249a and the second washer ring 249b may support the first coupling member 249e1 and the second coupling member 249e2, respectively, or may improve prevention of separation of the first shaft 231 and the second shaft 232 from fixing parts of the shaft fixing part 243, respectively. A hole may be formed at a central portion of the third washer ring 249c such that the first shaft 231 may pass therethrough, and the third washer ring 249c may be disposed between the first cam elastic body 242a and the first fixed cam portion 241a. Because the third washer ring 249c receives a pressure applied by the first cam elastic body 242a in advance and transfers the pressure to the cam member 241, the third washer ring 249c may remove direct contact between the cam member 241 and the first cam elastic body 242a to improve wear of the cam member 241 by the first cam elastic body 242a. The fourth washer ring 249d may perform the same role as that of the third washer ring 249c. For example, a hole may be formed at a central portion of the fourth washer ring 249d such that the second shaft 232 may pass therethrough, and the fourth washer ring 249d may be disposed between the second cam elastic body 242b and the second fixed cam portion 241b. The fourth washer ring 249d may perform a role of evenly receiving a pressure applied by the second cam elastic body 242b to the second fixed cam portion 241b in advance, and transferring the pressure to the second fixed cam portion 241b. Central portions of the plurality of ring structures (e.g., a first washer ring 249a, a second washer ring 249b, a third washer ring 249c, and a fourth washer ring 249d) may be provided in a circular shape, and may be maintained in a current state even when the first shaft 231 and the second shaft 232 are rotated.

According to an embodiment, a central portion of the first cam elastic body 242a (or the third elastic member) may have a hollow spring shape. At least a portion of a body of the first shaft 231 that has passed through the first fixed cam portion 241a may be seated on a central portion of the first cam elastic body 242a. Because the first cam elastic body 242a is disposed between the cam member 241 and the shaft fixing part 243, and the shaft fixing part 243 is fixed, the first cam elastic body 242a may act to push the cam member 241 in one direction (e.g., the y-axis direction).

According to an embodiment, a second cam elastic body 242b (or a fourth elastic member) may be disposed to be spaced apart from the first cam elastic body 242a by a specific interval, and may be disposed to contact one surface of the second fixed cam portion 241b. The second cam elastic body 242b may exert an elastic force on the second fixed cam portion 241b of the cam member 241 through the fourth washer ring 249d. An elastic force generated by the second cam elastic body 242b may be similar to an elastic force generated by the first cam elastic body 242a within a specific range.

The shaft fixing part 243 may include a shaft body 243_3, a first fixed portion 243_1, in which a first shaft hole is formed, and a second fixed portion 243_2, in which a second shaft hole is formed. The shaft body 243_3 may include a through-hole that passes upward and downward (e.g., the -z-axis direction at one point on the z-axis) and is used to fix the shaft fixing part 243 to the hinge housing 150 of FIG. 2. The first shaft hole formed at the first fixed portion 243_1 may be formed to pass in the y-axis direction or the -y-axis direction, and the first shaft 231 may be disposed to pass therethrough. A shape of the first shaft hole may be provided in a cylindrical shape differently from the z-axis cross-section of the first shaft 231. The first fixed portion 243_1 may support one side of the first cam elastic body 242a. The second shaft hole formed at the second fixed portion 243_2 may be disposed in parallel to the first shaft hole with respect to the y-axis, and may be formed to pass in the y-axis direction or the -y-axis direction, and the second shaft 232 may be disposed to pass therethrough. A shape of the second shaft hole may be provided in a cylindrical shape differently from the z-axis cross-section of the second shaft 232. The second fixed portion 243_2 may support one side of the second cam elastic body 242b.

In various embodiments, at least some gears provided in the portable communication device 100 may include one or more teeth, a width (or a thickness) of which is changed. As an example, a width of a gear tooth may become gradually larger or gradually smaller at a specific angle along a rotation axis of the gear. As an example, the gear tooth may be formed to include both a section in which a width is changed and a section in which a width is not changed.

According to an embodiment, a gear tooth may protrude from a gear body and may include a lower end that is close to the gear body, and an upper end that extends from the lower end. For example, the lower end may correspond to a height to a pitch circle diameter in the gear structure. For example, the upper end may correspond to a height from a pitch circle diameter to an addendum circle in the gear structure. For example, the lower end and the upper end of the gear tooth may protrude in a shape in which tooth surfaces are inclined at different angles with respect to the gear body. A distal end of the upper end (e.g., an addendum surface) may be formed to be flat. In an embodiment, a gear tooth, to which a gradient is applied, may have a constant width at the lower end, and may be formed in a gear tooth shape, a width of which is gradually changed only at the upper end. As an example, a gear tooth may be formed in a gear tooth shape, a width of which is changed at both the lower end and the upper end. For example, a gear tooth may be formed in a gear tooth shape, a width of which is changed at different angles at the lower end and the upper end.

According to an embodiment, a height (a height from a gear body) of the teeth of the gear may not be changed to be constant in a section in which a width of the teeth is changed. In an embodiment, the gear teeth may be formed in a gear tooth shape, in which a height (e.g., a height of the upper end) of the gear teeth is also changed such that an addendum circle diameter becomes gradually smaller in a section in which a width of the teeth is changed.

According to various embodiments of the disclosure, the first main gear 233a and the second main gear 233b may be rotated while being interlocked with each other through the first interlocking gear 234a and the second interlocking gear 234b located therebetween. The first interlocking gear 234a may deliver rotation of the first main gear 233a to the second interlocking gear 234b, between the first main gear 233a and the second interlocking gear 234b. The second interlocking gear 234b may deliver rotation of the first interlocking gear 234a to the second main gear 233b, between the first interlocking gear 234a and the second main gear 233b. As an example, one or more (e.g., two or four) interlocking gears may be provided between the first main gear 233a and the second main gear 233b.

According to an embodiment, the number of the gear teeth of the first interlocking gear 234a and/or the second interlocking gear 234b may be different from the number of the gear teeth of the first main gear 233a and/or the second main gear 233b. For example, the number of the gear teeth of the first interlocking gear 234a and/or the second interlocking gear 234b may be smaller than the number of the gear teeth of the first main gear 233a and/or the second main gear 233b.

According to an embodiment, a length of the first interlocking gear 234a and/or the second interlocking gear 234b may be different from a length of the first main gear 233a and/or the second main gear 233b. For example, a length of the first interlocking gear 234a and/or the second interlocking gear 234b may be greater than a length of the first main gear 233a and/or the second main gear 233b. As an example, a width of the gear teeth of the first interlocking gear 234a and/or the second interlocking gear 234b may be changed in a section corresponding to a length of the first main gear 233a and/or the second main gear 233b. As an example, a width of the gear teeth of the first interlocking gear 234a and/or the second interlocking gear 234b may not be changed in a section corresponding to a length that is greater than that of the first main gear 233a and/or the second main gear 233b. For example, the first interlocking gear 234a and/or the second interlocking gear 234b may be engaged with the first main gear 233a and/or the second main gear 233b in a section in which a width of the gear teeth is changed. For example, the first interlocking gear 234a and the second interlocking gear 234b may be engaged with each other in a section in which a width of the gear teeth is not changed.

According to an embodiment, the number of the gear teeth of the first interlocking gear 234a and/or the second interlocking gear 234b may be different in a section in which a width of the gear teeth is changed and a section in which the width is not changed.

According to an embodiment, the first interlocking gear 234a and/or the second interlocking gear 234b may be closely attached to the first main gear 233a and/or the second main gear 233b by using a force of an elastic body (e.g., a first gear elastic body 234s1 and/or a second gear elastic body 234s2).

According to an embodiment, intervals between the engaged teeth may be decreased by a gradient formed in the gear tooth shapes and the elasticity of the elastic body when the first and second main gear 233a and 233b and the first and second interlocking gear 234a and 234b are rotated while being engaged with each other. For example, the first and second main gear 233a and 233b and the first and second interlocking gear 234a and 234b may be maintained in a contact state when being rotated while engaged with each other.

According to an embodiment, the first interlocking gear 234a and the second interlocking gear 234b may not contact each other when being rotated while engaged with each other.

According to an embodiment, the first main gear 233a may be disposed in a form, in which it is integrated with the first shaft 231, and may be protected by the stopper 236. As an example, the first main gear 233a may be disposed between one side of the lower fixing bracket 213a in the -y-axis direction and one side of the stopper 236. The first main gear 233a may include a plurality of first gear teeth (or first main gear teeth). Some of the plurality of first gear teeth may include a first gradient area (or the gradient area of the first main gear 233a) in the -x-axis direction (or in a direction that faces a center from one periphery of the display 160 of FIG. 2 while being parallel to a folding axis of the display 160). The first gradient area may include, for example, an area (or a section), in which a thickness of the gear teeth gradually decreases as it goes from the x-axis in the -x-axis direction. Alternatively, the first gradient area may include an area in which at least one of a thickness or a height of the gear teeth gradually decreases as it goes from the x-axis in the -x-axis direction. According to an embodiment, the entire first main gear 233a may be formed as a gradient area. Alternatively, the first main gear 233a may include a flat area (or a non-gradient area) in a partial area.

The second main gear 233b may be disposed in a form, in which it is integrated with the second shaft 232, and may be protected by the stopper 236. As an example, the second main gear 233b may be disposed between an opposite side of the lower fixing bracket 213a in the -y-axis direction and an opposite side of the stopper 236. The second main gear 233b may include a plurality of second gear teeth (or second main gear teeth). The plurality of second gear teeth may have the same or similar shape as the first gear teeth described above. As an example, at least some of the second gear teeth may include a second gradient area (or the gradient area of the second main gear 233b), in which at least one of a thickness or a height of the gear teeth gradually decreases as it goes from the x-axis in the -x-axis direction. According to an embodiment, the entire second main gear 233b may be formed as a gradient area. Alternatively, the second main gear 233b may include a flat area (or a non-gradient area) in a partial area.

The first interlocking gear 234a may be disposed between the first main gear 233a and the second main gear 233b, and one side thereof may be geared with the first main gear 233a, and an opposite side thereof may be geared with the second interlocking gear 234b. The first interlocking gear 234a may include a projection that is inserted into a guide hole formed in the upper fixing bracket 213b, and a projection (or a shaft) that is fixed to one directional surface (e.g., a surface in the -y-axis direction) of the stopper 236. The teeth (or third gear teeth) of the first interlocking gear 234a, at least some of which are the teeth of an interlocking gear in at least a partial area that is geared with the first main gear 233a, may include a first interlocking gradient area (or a third gradient area). The first interlocking gradient area may have a shape in which at least one of a thickness or a height gradually decreases as it goes from the -x-axis in the x-axis direction. According to an embodiment, an entire area of the first interlocking gear 234a may be formed as a gradient area. Alternatively, a partial area of the first interlocking gear 234a may include a flat area (or a non-gradient area), and a remaining partial area may include a gradient area. According to an embodiment, the first interlocking gear 234a may be geared with the second interlocking gear 234b through a flat area (or a non-gradient area) formed in a partial area.

The second interlocking gear 234b may be disposed between the first main gear 233a and the second main gear 233b, and one side thereof may be geared with the first interlocking gear 234a, and an opposite side thereof may be geared with the second main gear 233b. The second interlocking gear 234b may be formed to have substantially the same shape and size as those of the first interlocking gear 234a. Accordingly, the second interlocking gear 234b may include a projection that is inserted into a guide hole formed in the upper fixing bracket 213b, and a projection (or a shaft) that is fixed to one directional surface (e.g., a surface in the -y-axis direction) of the stopper 236. The second interlocking gear 234b may include teeth (or fourth gear teeth), and at least some (e.g., the teeth of an interlocking gear in at least a partial area that is geared with the second main gear 233b) of the teeth of the second interlocking gear may include a second interlocking gradient area (or a fourth gradient area). The second interlocking gradient area may have a shape, similar to the first interlocking gradient area, in which at least one of a thickness or a height gradually decreases as it goes from the -x-axis in the x-axis direction. According to an embodiment, an entire area of the second interlocking gear 234b may be formed as a gradient area. Alternatively, a partial area of the second interlocking gear 234b may include a flat area (or a non-gradient area), and a remaining partial area may include a gradient area. According to an embodiment, the second interlocking gear 234b may be geared with the first interlocking gear 234a through a flat area (or a non-gradient area) formed in a partial area.

As described above, in a first type gear interlocking structure (or gear interlocking structure) of the hinge structure of the disclosure, at least one main gear and at least one interlocking gear may have gradient areas, respectively, and each of the gradient areas may be disposed to face each other. Alternatively, the gear interlocking structure of the hinge structure of the disclosure may include the first gradient area of the first main gear 233a and the second gradient area of the second main gear 233b, and the first interlocking gear 234a may include a first interlocking gradient area that is engaged with the first gradient area of the first main gear 233a, and the second interlocking gear 234b may include a second interlocking gradient area that is engaged with the second gradient area of the second main gear 233b. The first main gear 233a, the second main gear 233b, the first interlocking gear 234a, and the second interlocking gear 234b may be used to share a rotational force of the first shaft 231 and a rotational force of the second shaft 232. Based on the above-described structure, the hinge structure 201 of the disclosure may remove or improve (e.g., reduce a section) a free-play section, by removing or reducing a backlash section in which the gears are disengaged while the foldable electronic device 100 is folded within a specific angle range (e.g., around 10 degrees) of a designated range from a state (e.g., an included angle between the first housing 110 of FIG. 2 and the second housing 120 of FIG. 2 is 180 degrees, or an open state), in which the foldable electronic device 100 is held at a specific angle. For example, the foldable electronic device 100 of the disclosure may remove or improve indiscriminate shaking or an unintended motion (e.g., wobbling) of the user by removing or reducing at least a portion of a backlash section when the device is folded from the unfolded state (or in an opposite case).

Meanwhile, at least some of the components of the above-described hinge structure 201 may be omitted or replaced. For example, at least some of the plurality of ring structures (e.g., a first washer ring 249a, a second washer ring 249b, a third washer ring 249c, and a fourth washer ring 249d) may be removed. Furthermore, at least some of the other components of the hinge structure 201 may be removed or modified.

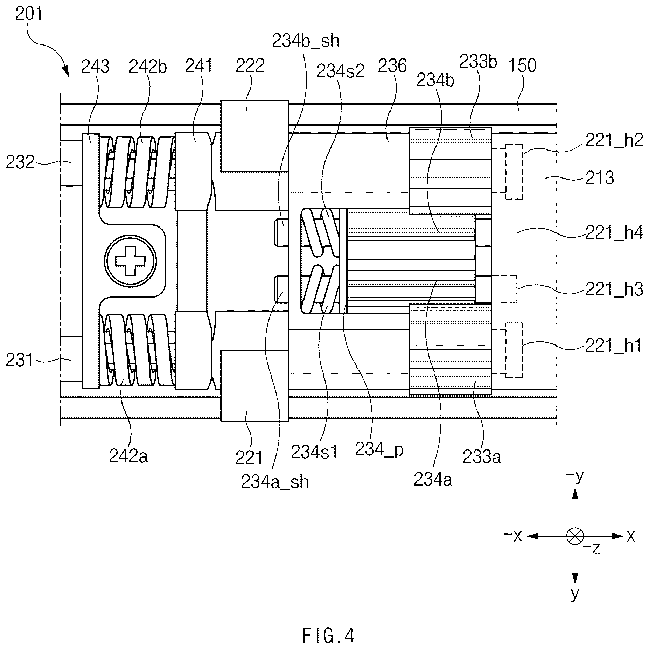

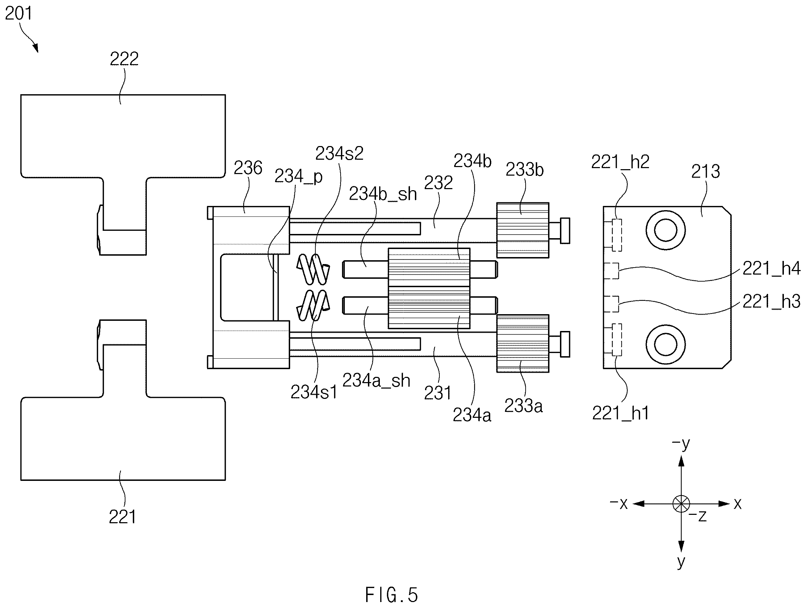

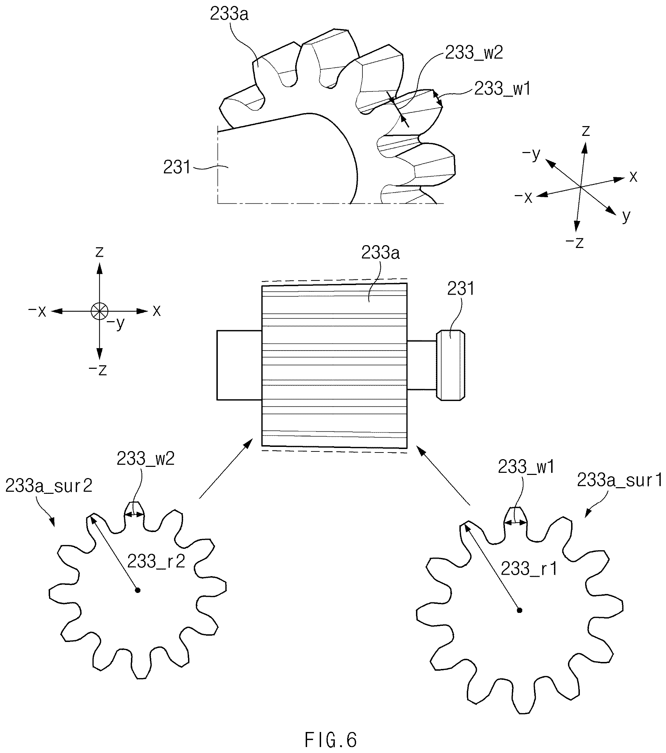

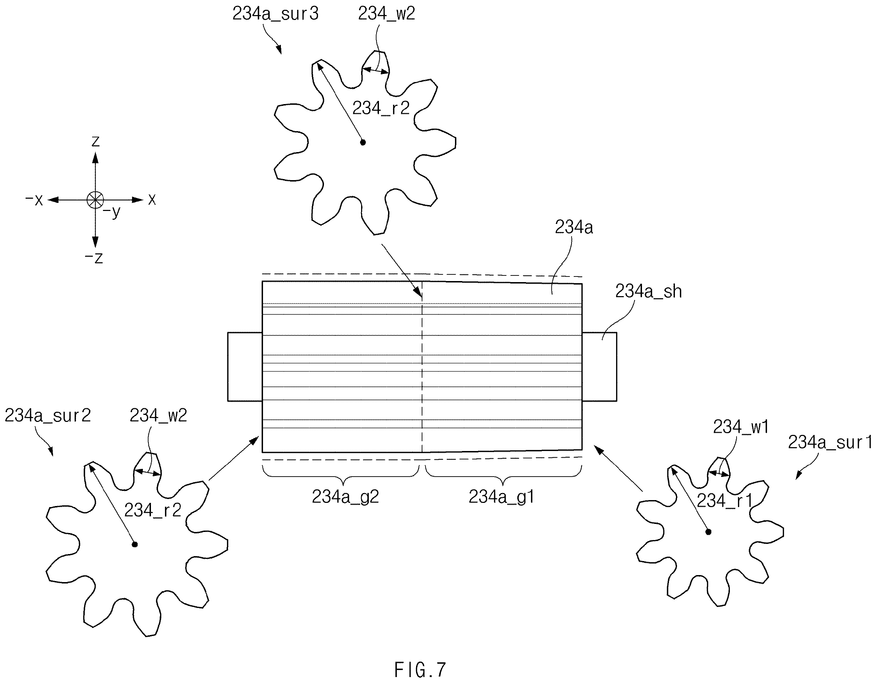

FIG. 4 is a view illustrating at least some of components related to a gear interlocking structure according to an embodiment. FIG. 5 is a view illustrating an exploded view of at least some of components related to a gear interlocking structure according to an embodiment. FIG. 6 is a view illustrating an example of a shape of a main gear according to an embodiment. FIG. 7 is a view illustrating an example of a shape of an interlocking gear according to an embodiment.

Referring to FIGS. 1 to 5, according to an embodiment, at least a portion of the hinge structure 201 may be seated in at least the hinge housing 150 of FIG. 2, and a stopper 236 (or a gear support portion), a first main gear 233a, a second main gear 233b, a first interlocking gear 234a, a second interlocking gear 234b, and an interlocking gear support portion 234_p may be disposed between the fixing bracket 213 and arm members (e.g., a first arm member 221 and a second arm member 222). Additionally, the hinge structure 201 may include a first cam elastic body 242a, a second cam elastic body 242b, and a cam member 241, which are disposed between the arm members 221 and 222 and a shaft fixing part 243. A ring structure may be further disposed between the cam member 241 and the cam elastic bodies 242a and 242b. As an example, the third washer ring 249c and the fourth washer ring 249d described above with reference to FIG. 3 may be disposed between the cam member 241 and the cam elastic bodies 242a and 242b. According to an embodiment, the third washer ring 249c and the fourth washer ring 249d may be connected to each other through a structure that is similar to or the same as that of the cam body 241c. The fixed cam portions of the cam member 241, in which peaks and valleys are formed, may be disposed to face the x-axis direction, and the fixed cam portions in which the peaks and valleys are formed may contact the cam structures formed in the arm members 221 and 222. The shaft fixing part 243 may have a structure (e.g., including holes into which screws may be inserted) that may be fixed to the hinge housing 150 of FIG. 2, and may include through-holes that are formed at opposite sides (e.g., side portions in the -y-axis and y-axis directions) to face the x-axis direction. At least portions of the first shaft 231 and the second shaft 232 may be disposed to pass through the through-holes.

According to an embodiment, the stopper 236 may support the first arm member 221 such that it does not exceed a design value (e.g., 180 degrees or 0 degrees corresponding to the xy plane) while the first arm member 221 is rotated in one direction (e.g., a direction in which it is rotated from the z-axis to the y-axis). Furthermore, the stopper 236 may support the second arm member 222 such that it does not exceed a design value (e.g., 0 degrees or 180 degrees corresponding to the xy plane) while the second arm member 222 is rotated in an opposite direction (e.g., a direction in which it is rotated from the z-axis to the -y-axis). A recess, on which the interlocking gear support portion 234_p may be held, may be provided on one side of the stopper 236. According to various embodiments, the interlocking gear support portion 234_p may be provided as one configuration (e.g., a form, in which the interlocking gear support portion 234_p is integrated with the stopper 236) of the stopper 236.

According to an embodiment, a one-side end of the first shaft 231 may be fixed by one side (e.g., a wing in the y-axis direction) of the shaft fixing part 243, the body of the first shaft 231 may be disposed to pass through one side of the first cam elastic body 242a, the first arm member 221, and the stopper 236, and an opposite-side end of the first shaft 231 may be held on or fixed to one side (e.g., a first recess 213_h1) of the fixing bracket 213. A first main gear 233a may be disposed at an x-axis periphery of the first shaft 231.

According to an embodiment, a one-side end of the second shaft 232 may be fixed by an opposite side (e.g., a wing in the -y-axis direction) of the shaft fixing part 243, a body of the second shaft 232 may be disposed to pass through an opposite side of the second cam elastic body 242b, the second arm member 222, and the stopper 236, and an opposite-side end of the second shaft 232 may be held on or fixed to an opposite side (e.g., a second recess 213_h2) of the fixing bracket 213. A second main gear 233b may be disposed at an x-axis periphery of the second shaft 232. With respect to a folding axis, along which the display 160 of FIG. 2 is folded, or with respect to a center line between the first shaft 231 and the second shaft 232 on the xy plane, the first main gear 233a and the second main gear 233b may be disposed to have the same structure at symmetrical positions.

According to an embodiment, a third shaft 234a_sh may be disposed at a central portion of the first interlocking gear 234a. The third shaft 234a_sh may be disposed in parallel to the first shaft 231, and a one-side (e.g., the -x-axis) periphery may be held on (or fixed to) the stopper 236, and an opposite-side (e.g., the x-axis) periphery may be held on (or fixed to) a third recess 213_h3 of the fixing bracket 213. The third shaft 234a_sh may be disposed between the first shaft 231 and the second shaft 232. Alternatively, the third shaft 234a_sh may be disposed between the first shaft 231 and the fourth shaft 234b_sh. A first gear elastic body 234s1 may be held on the third shaft 234a_sh.

According to an embodiment, a fourth shaft 234b_sh may be disposed at a central portion of the second interlocking gear 234b. The fourth shaft 234b_sh may be disposed in parallel to the second shaft 232, and a one-side (e.g., the -x-axis) periphery may be held on (or fixed to) the stopper 236, and an opposite-side (e.g., the x-axis) periphery may be held on (or fixed to) a fourth recess 213_h4 of the fixing bracket 213. The fourth shaft 234b_sh may be disposed between the first shaft 231 and the second shaft 232. Alternatively, the fourth shaft 234b_sh may be disposed between the second shaft 232 and the third shaft 234a_sh. A second gear elastic body 234s2 may be held on the fourth shaft 234b_sh.

According to an embodiment, the first gear elastic body 234s1 may be disposed between the stopper 236 and the interlocking gear support portion 234_p. The first gear elastic body 234s1 may exert an elastic force to push the interlocking gear support portion 234_p in the -x-axis direction (or toward the first main gear 233a or the second main gear 233b). Correspondingly, the first interlocking gear 234a may closely contact the first main gear 233a by an elastic force transferred through the interlocking gear support portion 234_p.

According to an embodiment, the second gear elastic body 234s2 may be disposed between the stopper 236 and the interlocking gear support portion 234_p, and may be disposed in parallel to the first gear elastic body 234s1. The second gear elastic body 234s2 may exert an elastic force, together with the first gear elastic body 234s1, to push the interlocking gear support portion 234_p in the x-axis direction (or toward the first main gear 233a or the second main gear 233b). Correspondingly, the second interlocking gear 234b may closely contact the second main gear 233b by an elastic force transferred through the interlocking gear support portion 234_p. The second gear elastic body 234s2 may be disposed symmetrically to the first gear elastic body 234s1 with respect to a transverse center line (or the x-axis) of the hinge structure 201. The second gear elastic body 234s2 may have the same (or similar within a certain range) size and elasticity as the first gear elastic body 234s1.

According to an embodiment, at least one of the first gear elastic body 234s1 and the second gear elastic body 234s2 may include a spring, a leaf spring, or a clip (e.g., a C-clip). For example, at least one of the first gear elastic body 234s1 and the second gear elastic body 234s2 may include a material of metal (e.g., stainless steel), rubber, or plastic. As an example, the first gear elastic body 234s1 and the second gear elastic body 234s2 may be formed integrally.

Referring to FIGS. 1 to 6, a first main gear 233a according to an embodiment may include a plurality of first gear teeth (e.g., twelve), and the plurality of first gear teeth (or at least some of the first gear teeth) may be radially disposed on the zy plane from a central axis of the first shaft 231. As an example, a central portion of a z-axis cross-section of the first main gear 233a may be formed to be circular, the first main gear 233a may have a cylindrical shape in the x-axis direction, and gear teeth may be disposed on an outer surface thereof. The number of the plurality of first gear teeth may vary depending on a size of the applied foldable electronic device 100 (or the hinge structure 201), a material of the first main gear 233a, or an intention of a designer. At least one of a thickness and a height of the plurality of first gear teeth may be changed as it goes from the x-axis in the -x-axis direction (or in a direction from the fixing bracket 213 toward the shaft fixing part 243, or a first direction). As an example, heights of the plurality of first gear teeth may be maintained to be the same in a first direction, and thicknesses of the plurality of first gear teeth may be gradually reduced (thinned) in the first direction. Alternatively, as heights of the plurality of first gear teeth may be gradually reduced (or lowered) in a first direction, thicknesses of the plurality of first gear teeth may be gradually reduced (thinned) in the first direction. When observation directions are different, for example, when viewed from the -x-axis in an x-axis direction (or in a direction that faces the fixing bracket 213 from the shaft fixing part 243, or in a second direction), at least one of a thickness and a height of first gear teeth of the first main gear 233a may be gradually increased as it goes in the second direction.

According to an embodiment of the disclosure, referring to FIG. 6, a periphery of each of the plurality of first gear teeth of the first main gear 233a in the x-axis direction (or in a direction in which it is held on the fixing bracket 213) may have a first thickness 233_w1, and a periphery of each of the plurality of first gear teeth of the first main gear 233a in the -x-axis direction (or in a direction of the stopper 236 or a direction of the shaft fixing part 243) may have a second thickness 233_w2 that is thinner than the first thickness 233_w1. When observed in a direction from the x-axis toward the -x-axis, a first gear surface 233a_sur1 of the first main gear 233a may represent a structure including the plurality of first gear teeth, as illustrated. A specific gear tooth of the first gear surface 233a_sur1 may have a first thickness 233_w1, as illustrated. According to an embodiment of the disclosure, a radius from a center of the first gear surface 233a_sur1 to an end of a specific gear tooth (e.g., a tip circle radius) may have a first length 233_r1. When observed in a direction from the -x-axis toward the x-axis, a second gear surface 233a_sur2 of the first main gear 233a may represent a structure including the plurality of first gear teeth, as illustrated. A specific gear tooth of the second gear surface 233a_sur2 may have a second thickness 233_w2, which is different from the first thickness 233_w1, as illustrated. As an example, the second thickness 233_w2 may have a size that is smaller (thinner) than the first thickness 233_w1. According to an embodiment of the disclosure, a radius from a center of the second gear surface 233a_sur2 to an end of a specific gear tooth (e.g., a tip circle radius) may have a second length 233_r2, which is different from the first length 233_r1. As an example, the second length 233_r2 may have a size that is smaller (shorter) than the first length 233_r1. According to various embodiments, as described above, first gear teeth of the first main gear 233a may differ only in thickness without a change in height, depending on their positions. In this case, a first thickness 233_w1 corresponding to a tooth width in an arc of the first gear surface 233a_sur1 and a second thickness 233_w2 corresponding to a tooth width in an arc of the second gear surface 233a_sur2 may be formed to be different, and a first length 233_r1 of a tip circle radius of the first gear surface 233a_sur1 and a second length 233_r2 of a tip circle radius of the second gear surface 233a_sur2 may be designed to be the same.

According to an embodiment, a second main gear 233b may include a plurality of second gear teeth (e.g., twelve), and the plurality of second gear teeth (or at least some of the second gear teeth) may be radially disposed on the zy plane from a central axis of the second shaft 232. As an example, a central portion of a z-axis cross-section of the second main gear 233b may be formed to be circular, the first main gear 233a may have a cylindrical shape in the x-axis direction, and gear teeth may be disposed on an outer surface thereof. The number of the plurality of second gear teeth may vary depending on a size of the applied foldable electronic device 100 (or the hinge structure 201), a material of the second main gear 233b, or an intention of a designer. The plurality of second gear teeth of the second main gear 233b may have the same number and the same shape as those of the first gear teeth. For example, at least one of a thickness and a height of the plurality of second gear teeth may be changed as it goes from the x-axis in the -x-axis direction (or in a direction from the fixing bracket 213 toward the shaft fixing part 243, or a first direction). As an example, heights of the plurality of second gear teeth may be maintained to be the same in a first direction, and thicknesses of the plurality of second gear teeth may be gradually reduced (thinned) in the first direction. Alternatively, as heights of the plurality of second gear teeth may be gradually reduced (or lowered) in a first direction, thicknesses of the plurality of second gear teeth may be gradually reduced (thinned) in the second direction. When observation directions are different, for example, when viewed from the -x-axis in an x-axis direction (or in a direction that faces the fixing bracket 213 from the shaft fixing part 243, or in a second direction), similarly to the first main gear 233a, at least one of a thickness and a height of second gear teeth of the second main gear 233b may be gradually increased as it goes in the second direction.

Referring to FIGS. 1 to 7, a third shaft 234a_sh may be disposed at a center of the first interlocking gear 234a, and the teeth (or the third gear teeth) of the plurality (e.g., nine) of first interlocking gear may be disposed to surround at least a portion of the third shaft 234a_sh. Teeth of the first interlocking gear may include an area in which a gradient is formed and an area in which a gradient is not formed, depending on positions. For example, the first interlocking gear 234a may include a first non-gradient area 234a_g2 (or a first flat area) in which no gradient is formed from a - x-axis periphery to a central portion, and a first interlocking gradient area 243a_g1 (or a third gradient area) in which a gradient is formed from the central portion to an x-axis periphery. Lengths of the first non-gradient area 234a_g2 and the first interlocking gradient area 243a_g1 in the x-axis direction may be formed to be the same (or similar within a specific range). Alternatively, depending on a length or a shape of the first main gear 233a, the lengths of the first non-gradient area 234a_g2 and the first interlocking gradient area 243a_gl may be different.

A height (e.g., a length from a center of the third shaft 234a_sh to an end of a gear tooth) and a thickness (or a tooth width in an arc, or a width thereof) of the teeth of the first interlocking gear in the first non-gradient area 234a_g2 may be formed to be substantially the same or the same/similar within a specific error range. At least one of a thickness and a height of the teeth of the first interlocking gear in the first interlocking gradient area 243a_g1 may be changed as it goes in the x-axis direction. A thickness (e.g., a tooth width) (or a thickness of each of the teeth of the first interlocking gear located at a portion adjacent to the fixing bracket 213) of each of the teeth of the first interlocking gear 234a located at an x-axis periphery may have a third thickness 234_w1, and a thickness (e.g., a tooth width) of each of the teeth of the first interlocking gear 234a located at a central portion of the first interlocking gear 234a may have a fourth thickness 234_w2 that is different from the third thickness 234_w1. As an example, the third thickness 234_w1 may be smaller (thinner) than the fourth thickness 234_w2. When observed in a direction from the x-axis toward the -x-axis, a width of each of the teeth of the plurality of first interlocking gears disposed on a first interlocking gear surface 234a_sur1 of the first interlocking gear 234a may have a third thickness 234_w1, and a tip circle radius may have a third length 234_r1. When observed in a direction from a -x-axis periphery of the first interlocking gear 234a toward the x-axis direction, each of the teeth of a second interlocking gear surface 234a_sur2 of the first interlocking gear 234a may have a fourth thickness 234_w2 that is greater than the third thickness 234_w1 and a fourth length 234_r2 that is greater than the third length 234_r1. A third interlocking gear surface 234a_sur3 (e.g., a cross-section obtained by cutting the central portion along the z-axis) of a central portion (e.g., a point at which a first non-gradient area 234a_g2 and a first interlocking gradient area 243a_g1 meet each other) of the first interlocking gear 234a may be formed to be the same as a second interlocking gear surface 234a_sur2.

According to various embodiments, as described above, first gear teeth of the first interlocking gear 234a may differ only in thickness without a change in height, depending on their positions. In this case, a third thickness 234_w1 corresponding to a width of an arc tooth of a first interlocking gear surface 234a_sur1 and a fourth thickness 234_w2 corresponding to a width of an arc tooth of a second interlocking gear surface 234a_sur2 (or a third interlocking gear surface 234a_sur3) may be formed differently, and a third length 234_r1 of a tip circle radius of the first interlocking gear surface 234a_sur1 and a fourth length 234_r2 of a tip circle radius of the second interlocking gear surface 234a_sur2 (or the third interlocking gear surface 234a_sur3) may be designed to be substantially the same or to be the same or similar within a predetermined tolerance.

According to an embodiment, the second interlocking gear 234b may have the same structure as that of the above-described first interlocking gear 234a. As an example, the second interlocking gear 234b may have a second non-gradient area corresponding to a first non-gradient area 234a_g2 of the first interlocking gear 234a, and may include a second interlocking gradient area corresponding to a first interlocking gradient area 243a_g1 of the second interlocking gear 234b. A shape and a size of the second non-gradient area may have a shape and a size that are the same as, or similar within a specific range to, those of the first non-gradient area 234a_g2, and a shape and a size of the second interlocking gradient area may have a shape and a size that are the same as, or similar within a specific range to, those of the first interlocking gradient area 243a_g1. According to various embodiments, the interlocking gears 234a and 234b may be configured to include only interlocking gradient areas without non-gradient areas.

According to an embodiment, a direction of gradients of the main gear and the interlocking gear may be formed in a different direction (e.g., an opposite direction to) from the above-described embodiments.

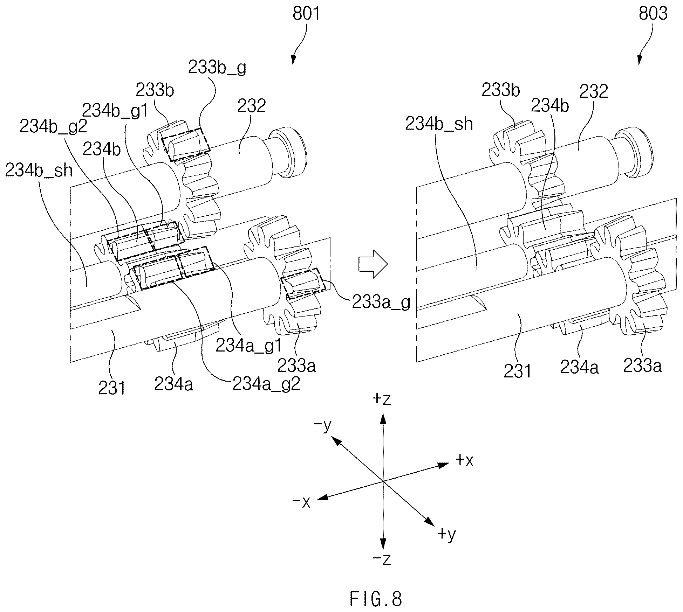

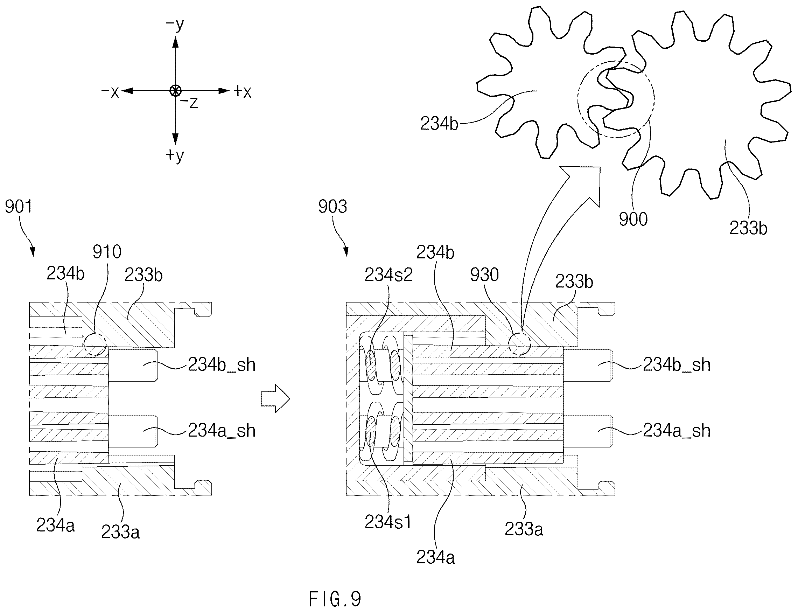

FIG. 8 is a perspective view illustrating a coupled form of gears according to an embodiment. FIG. 9 is a front view illustrating a coupled form of gears according to an embodiment.

Referring to FIGS. 1 to 9, a hinge structure 201 according to an embodiment may include at least, for example, a first main gear 233a, a second main gear 233b, a first interlocking gear 234a, and a second interlocking gear 234b. According to an embodiment, as in state 801, the first main gear 233a of the hinge structure 201 may include a first gradient area 233a_g, of which thicknesses of first gear teeth become gradually larger as it goes from the -x-axis to the x-axis direction. Alternatively, all of the first gear teeth of the first main gear 233a may form a gradient in which a thickness (or a tooth width) becomes gradually larger as it goes from the -x-axis to the x-axis direction. Similarly, all of the second gear teeth of the second main gear 233b may form a gradient in which a thickness (or a tooth width) becomes gradually larger as it goes from the -x-axis to the x-axis direction. As an example, the first gear teeth of the first main gear 233a and the second gear teeth of the second main gear 233b may have the same (or similar within a specific range) size, shape, and thickness variation. The first interlocking gear 234a may include, for example, a first interlocking gradient area 243a_g1, in which a thickness of teeth of the first interlocking gear becomes gradually larger as it goes from the x-axis to the -x-axis direction, and a first non-gradient area 234a_g2 (or a first flat area) that is connected to the first interlocking gradient area 243a_g1 and extends in the -x-axis direction. Similarly, the second interlocking gear 234b may include a second interlocking gradient area 234b_g1, in which a thickness of teeth of the second interlocking gear becomes gradually larger as it goes from the x-axis to the -x-axis direction, and a second non-gradient area 234b_g2 (or a second flat area) that is connected to the second interlocking gradient area 234b_g1 and extends in the -x-axis direction.

According to an embodiment, as in state 803, in a state in which the first main gear 233a and the second main gear 233b are fixed, the first interlocking gear 234a and the second interlocking gear 234b may be moved in the x-axis direction, or when the first main gear 233a and the second main gear 233b are moved in a direction that faces the first interlocking gear 234a and the second interlocking gear 234b, the first main gear 233a may be geared with one side of the first interlocking gear 234a, and the second main gear 233b may be geared with one side of the second interlocking gear 234b.

Referring to state 901, while a one-side (e.g., the -x-axis periphery) end of the first main gear 233a and a one-side (e.g., the x-axis periphery) end of the first interlocking gear 234a overlap each other with respect to the y-axis, a second gradient area 233b_g of the second main gear 233b and a second interlocking gradient area 234b_g1 of the second interlocking gear 234b overlap each other, and thus, the second main gear 233b and the second interlocking gear 234b are disposed to overlap each other substantially with respect to the y-axis, but they may not be engaged with each other and may be in a spaced state 910. Similarly, the first main gear 233a and the first interlocking gear 234a may be in a spaced state without being engaged with each other with respect to the y-axis.

Referring to state 903, when a first gear elastic body 234s1 exerts an elastic force such that the first interlocking gear 234a is moved toward the first main gear 233a, teeth of the first interlocking gear 234a may be moved between first gear teeth of the first main gear 233a to be geared with them. Correspondingly, a first interlocking gradient area 243a_g1 of the first interlocking gear 234a may be geared with the first main gear 233a (e.g., a first gradient area 233a_g), and a first non-gradient area 234a_g2 of the first interlocking gear 234a may be geared with a second non-gradient area 234b_g2 of the second interlocking gear 234b.

Similarly, when a second gear elastic body 234s2 exerts an elastic force such that the second interlocking gear 234b is moved toward the second main gear 233b, teeth of the second interlocking gear 234b may be moved between second gear teeth of the second main gear 233b to be geared with them. Correspondingly, a second interlocking gradient area 234b_g1 of the second interlocking gear 234b may be geared with the second main gear 233b (e.g., a second gradient area 233b_g), and a second non-gradient area 234b_g2 of the second interlocking gear 234b may be geared with a first non-gradient area 234a_g2 of the first interlocking gear 234a. When the second interlocking gradient area 234b_g1 of the second interlocking gear 234b is geared with the second gradient area 233b_g of the second main gear 233b, gradient surfaces may be in an overlapping state 930 with respect to the y-axis direction. In a state 930, in which gradient surfaces overlap each other, as illustrated, second gear teeth of the second main gear 233b and second interlocking gear teeth of the second interlocking gear 234b may be disposed to be engaged with each other with no gap, and thus, backlash may be removed.

As described above, the gradient areas of the first main gear 233a and the first interlocking gear 234a (or the second main gear 233b and the second interlocking gear 234b) may be geared with each other face to face, and the non-gradient areas of the first interlocking gear 234a and the second interlocking gear 234b may be formed to be geared with each other. Accordingly, backlash between the first main gear 233a and the first interlocking gear 234a may be formed to be smaller or removed as compared to gear coupling of existing non-gradient areas. Similarly, backlash between the second main gear 233b and the second interlocking gear 234b may be formed to be smaller or removed as compared to gear coupling of existing non-gradient areas.

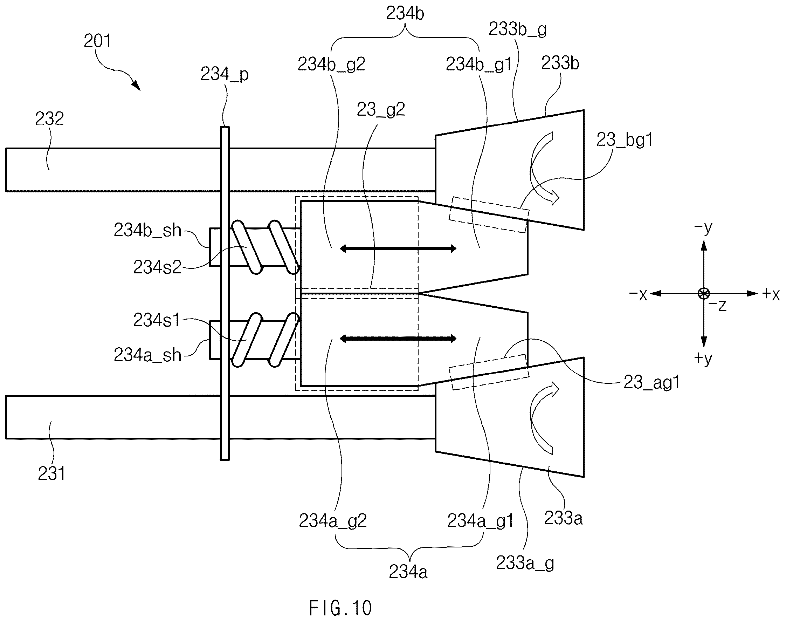

FIG. 10 is a view related to a description of an operation situation of a gear interlocking structure of a hinge structure according to an embodiment.

Referring to FIGS. 1 to 10, the hinge structure 201 according to an embodiment may include a gear interlocking structure having a first main gear 233a that is disposed on a first shaft 231, a second main gear 233b that is disposed on a second shaft 232, a first interlocking gear 234a that is disposed on a third shaft 234a_sh, a second interlocking gear 234b that is disposed on a fourth shaft 234b_sh, an interlocking gear support portion 234_p that supports the first interlocking gear 234a and the second interlocking gear 234b, a first gear elastic body 234s1 that is disposed between the interlocking gear support portion 234_p and the first interlocking gear 234a, and a second gear elastic body 234s2 that is disposed between the interlocking gear support portion 234_p and the second interlocking gear 234b. Additionally or alternatively, the hinge structure 201 may further include a first arm member 221 that is coupled to the first shaft 231, and a second arm member 222 that is coupled to the second shaft 232. As described above, because link members that are coupled to (or integrated with) a first housing 110 of FIG. 2 and a second housing 120 of FIG. 2 are coupled to the arm members 221 and 222, when an external pressure (e.g., a force for folding or unfolding the foldable electronic device 100 after being gripped by a user) is exerted to at least one of the first housing 110 and the second housing 120, the link members connected to the first housing 110 and the second housing 120 may rotate the arm members 221 and 222, and the rotations of the arm members 221 and 222 may be transferred to the first shaft 231 and the second shaft 232. The first shaft 231 and the second shaft 232 may be rotated in a first rotational direction or a second rotational direction that are different from each other in response to rotations of the arm members 221 and 222.

According to an embodiment, when the first shaft 231 is rotated in the first rotational direction, the first main gear 233a may be rotated in the first rotational direction in response to the rotation of the first shaft 231, and the first interlocking gear 234a that is geared with 23_ag1 (e.g., the first interlocking gradient area 243a_g1 of the first interlocking gear 234a and the first gradient area 233a_g of the first main gear 233a are geared with each other) with the first gradient area 233a_g of the first main gear 233a may be rotated in the second rotational direction that is opposite to the rotational direction of the first main gear 233a. The first interlocking gear 234a may include a first non-gradient area 243a_g2 that is connected to the first interlocking gradient area 243a_g1, and the first non-gradient area 234a_g2 may be geared 23_g2 with a second non-gradient area 234b_g2 of the second interlocking gear 234b. Alternatively, the first non-gradient area 234a_g2 and the second non-gradient area 234b_g2 may be interlocked in a geared state. According to an embodiment, a rotational force of the first interlocking gradient area 243a_g1 may be transferred to the first non-gradient area 234a_g2, and the rotational force of the first non-gradient area 234a_g2 may rotate a second non-gradient area 234b_g2 of the second interlocking gear 234b in the first rotational direction (or clockwise when viewed from the x-axis toward the -x-axis). A second interlocking gradient area 234b_g1 connected to the second non-gradient area 234b_g2 may be in a state of being geared 23bg1 with a second gradient area 233b_g of the second main gear 233b. Accordingly, in response to a rotation of the second interlocking gradient area 234b_g1 of the second interlocking gear 234b, the second main gear 233b may be rotated in the second rotational direction (or counterclockwise when viewed from the x-axis toward the -x-axis).

As described above, when the foldable electronic device 100 is changed from an unfolded state to a folded state, the first main gear 233a and the second main gear 233b may be rotated in facing directions, and the first interlocking gear 234a and the second interlocking gear 234b may be rotated in opposite directions to each other. Alternatively, when the foldable electronic device 100 is changed from a folded state to an unfolded state, the first main gear 233a and the second main gear 233b may be rotated in opposite directions to each other, and the first interlocking gear 234a and the second interlocking gear 234b may be rotated in facing directions. In the above-described rotation process, while the first main gear 233a and the second main gear 233b are rotated, the first interlocking gear 234a and the second interlocking gear 234b geared 23_bg1 and 23_ag1 with the gradient surfaces may be reciprocally linearly moved in the -x-axis and the x-axis while being rotated. For example, while being moved between other first gear teeth of the first main gear 233a from between the first gear teeth of the first main gear 233a, the first interlocking gear teeth of the first interlocking gear 234a may be retracted by a specific distance in the -x-axis direction, and then, may be moved in the x-axis direction. Alternatively, in response to a change in the folded or unfolded state of the foldable electronic device 100, while first interlocking gear teeth of the first interlocking gear 234a are moved between first gear teeth of the first main gear 233a, gear-coupling extents (e.g., 23_ag1) (or contact extents) of the gradient areas of the first interlocking gear 234a and the first main gear 233a may be repeatedly decreased and increased. Similarly to the above-described operation, while the second interlocking gear 234b and the second main gear 233b are rotated in different rotational directions, second interlocking gear teeth of the second interlocking gear 234b are moved between second gear teeth of the second main gear 233b, and in a process of moving the second interlocking gear teeth, the second interlocking gear 234b may be linearly retracted in the -x-axis direction, and then, may be linearly moved forward. In response to a reciprocating linear movement of the second interlocking gear 234b, gear-coupling extents 23_bg1 of the gradient areas of the second interlocking gear 234b and the second main gear 233b may be repeatedly decreased or increased.

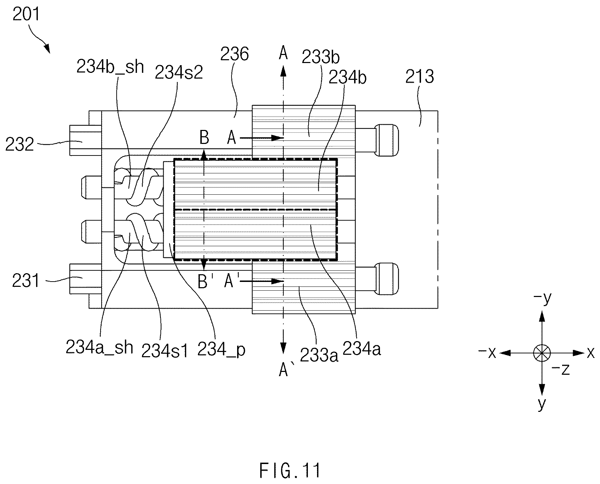

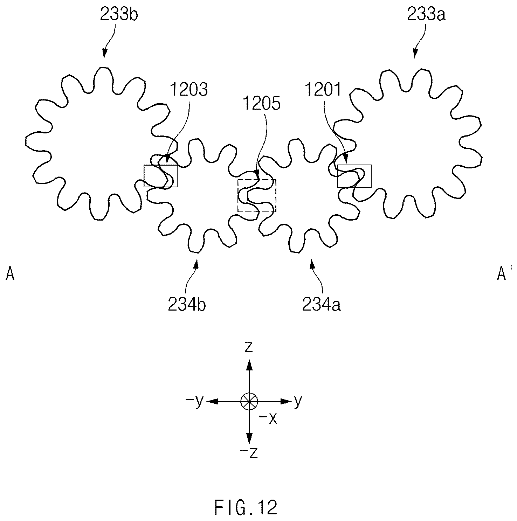

FIG. 11 is a view illustrating some components related to a gear interlocking structure of a hinge structure according to an embodiment. FIG. 12 is a view illustrating a partial cross-section of a gear interlocking structure according to an embodiment. FIG. 13 is a view illustrating another partial cross-section of a gear interlocking structure according to an embodiment. As an example, FIG. 12 is a view illustrating an example of a cross-section taken along line A-A' of FIG. 11, and FIG. 13 is a view illustrating an example of a cross-section taken along line B-B' of FIG. 11.

Referring to FIGS. 1 to 12, the hinge structure 201 may include at least a fixing bracket 213, a stopper 236, a first shaft 231, a second shaft 232, a first main gear 233a, a second main gear 233b, a first interlocking gear 234a, a second interlocking gear 234b, an interlocking gear support portion 234_p, a first gear elastic body 234s1, and a second gear elastic body 234s2. As illustrated in FIG. 12, a cross-section taken along line A-A' may have a state in which the first interlocking gear 234a and the second interlocking gear 234b are disposed between the first main gear 233a and the second main gear 233b. As an example, the first gear elastic body 234s1 may exert an elastic force to press the first interlocking gear 234a in the x-axis direction (or in a direction from the stopper 236 toward the fixing bracket 213). Correspondingly, a first interlocking gradient area 243a_g1 of the first interlocking gear 234a may be geared with the first main gear 233a, and may have a face-to-face gear-coupling state 1201 capable of reducing a size of a backlash section. As an example, the second gear elastic body 234s2 may exert an elastic force to press the second interlocking gear 234b in the x-axis direction (or in a direction from the stopper 236 toward the fixing bracket 213). Correspondingly, a second interlocking gradient area 234b_g1 of the second interlocking gear 234b may be geared with the second main gear 233b, and may have a face-to-face gear-coupling state 1203 capable of reducing an occurrence of a backlash section (or a size of the backlash section). According to an embodiment, a first non-gradient area 234a_g2 of the first interlocking gear 234a may be geared with a second non-gradient area 234b_g2 of the second interlocking gear 234b, and as illustrated, may have a gear-coupling state 1205 in which a gap or backlash of a specific size is formed.

Referring to FIGS. 1 to 13, a cross-section taken along line B-B' may have a state in which the first interlocking gear 234a and the second interlocking gear 234b are disposed between the first main gear 233a and the second main gear 233b, as illustrated in FIG. 13. As an example, the first gear elastic body 234s1 may exert an elastic force to press the first interlocking gear 234a in the x-axis direction (or in a direction from the stopper 236 toward the fixing bracket 213), and the second gear elastic body 234s2 may exert an elastic force to press the second interlocking gear 234b in the x-axis direction. Correspondingly, a first interlocking gradient area 243a_g1 of the first interlocking gear 234a and a second interlocking gradient area 234b_g1 of the second interlocking gear 234b may be located between the first main gear 233a and the second main gear 233b, and the first non-gradient area 234a_g2 and the second non-gradient area 234b_g2 may have a geared state.

As a first interlocking gradient area 234a_g1 of the first interlocking gear 234a and a second interlocking gradient area 234b_g1 of the second interlocking gear 234b may be geared with the first main gear 233a and the second main gear 233b, respectively, and the first gear elastic body 234s1 and the second gear elastic body 234s2 press the first interlocking gear 234a and the second interlocking gear 234b in the x-axis direction, the first main gear 233a and the second main gear 233b may press the first interlocking gear 234a and the second interlocking gear 234b inward. Correspondingly, a first non-gradient area 234a_g2 of the first interlocking gear 234a and a second non-gradient area 234b_g2 of the second interlocking gear 234b may have a geared state 1303 that is more closely engaged even in a state without a gradient.

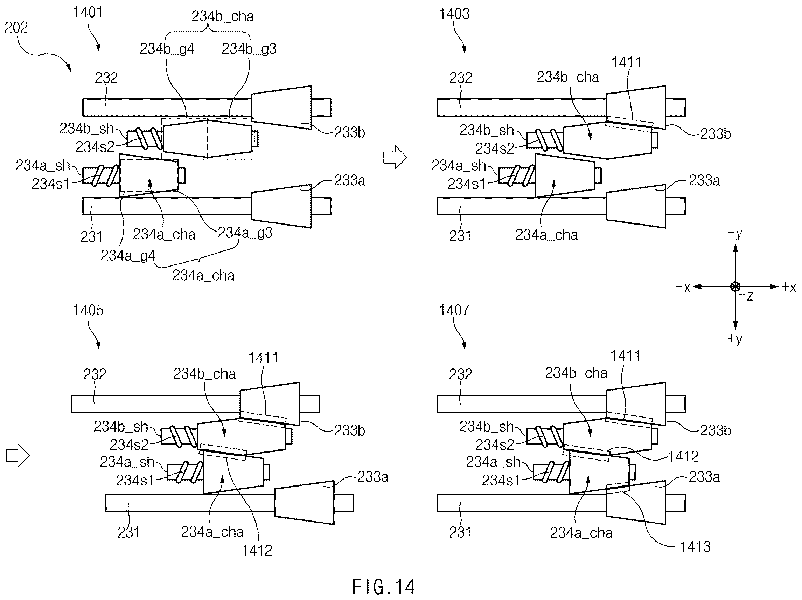

FIG. 14 is a view illustrating an example of a second type gear interlocking structure included in a hinge structure according to an embodiment.

Referring to FIGS. 1 to 14, the hinge structure 202 according to an embodiment, as illustrated in state 1401, may include a second type gear interlocking structure (or a modified gear interlocking structure) having at least a first main gear 233a, a first shaft 231 that is disposed at a central portion of the first main gear 233a, a second main gear 233b, a second shaft 232 that is disposed at a central portion of the second main gear 233b, a first modified interlocking gear 234a_cha, a third shaft 234a_sh that is disposed at a central portion of the first modified interlocking gear 234a_cha, a second modified interlocking gear 234b_cha, a fourth shaft 234b_sh that is disposed at a central portion of the second modified interlocking gear 234b_cha, a first gear elastic body 234s1 that is inserted into the third shaft 234a_sh, and a second gear elastic body 234s2 that is inserted into the fourth shaft 234b_sh. The above-described modified gear interlocking structure may have the same structure, except for the first modified interlocking gear 234a_cha and the second modified interlocking gear 234b_cha, compared to the gear interlocking structure described with reference to FIG. 10. For example, the first main gear 233a and the first shaft 231, and the second main gear 233b and the second shaft 232 may correspond to the components described in FIG. 10 above. The first modified interlocking gear 234a_cha may include, for example, modified gradient areas 234a_g3 and 234a_g4. For example, at least one of a thickness and a height of the first modified interlocking gear teeth of 234a_g3 and 234a_g4 may become gradually larger as they go from the x-axis periphery to the -x-axis periphery of the first modified interlocking gear 234a_cha. Alternatively, for example, an interval between the teeth of the first modified interlocking gear 234a_cha in 234a_g3 and 234a_g4 may become gradually smaller as they go from the x-axis periphery to the -x-axis periphery of the first modified interlocking gear 234a_cha. The modified gradient areas 234a_g3 and 234a_g4 may include a leading area 234a_g3 that is geared with the first main gear 233a, and a trailing area 234a_g4 that is geared with the second modified interlocking gear 234b_cha.

The second modified interlocking gear 234b_cha may include, for example, a first modified gradient area 234b_g3 and a second modified gradient area 234b_g4. For example, at least one of a thickness and a height of the second modified interlocking gear teeth of the first modified gradient area 234b_g3 may become gradually smaller as they go in the x-axis direction with respect to a central area of the second modified interlocking gear 234b_cha. For example, at least one of a thickness and a height of the second modified interlocking gear teeth of the second modified gradient area 234b_g4 may become gradually smaller as they go in the -x-axis direction with respect to a central area of the second modified interlocking gear 234b_cha. Alternatively, in the first modified gradient area 234b_g3 and the second modified gradient area 234b_g4, a thickness of the teeth of the second modified interlocking gear disposed at a central portion area of the second modified interlocking gear 234b_cha may be formed to be greater than a thickness of the teeth of the second modified interlocking gear 234b_cha disposed at opposite peripheries thereof. Alternatively, in the first modified gradient area 234b_g3 and the second modified gradient area 234b_g4, a height of the gear teeth of the second modified interlocking gear 234b_cha disposed at a central portion area of the second modified interlocking gear 234b_cha may be formed to be greater than a height of the gear teeth of the second modified interlocking gear 234b_cha disposed at opposite peripheries thereof.

The modified gear interlocking structure having the above-described structure may have a first gear coupling area 1411, in which one side (e.g., a second gradient area of the second main gear 233b) of the second main gear 233b and a first modified gradient area 234b_g3 of the second modified interlocking gear 234b_cha are geared with each other, as in state 1403. In the first gear coupling area 1411, as the first modified gradient area 234b_g3 is inserted into the second gradient area of the second main gear 233b, backlash may not be generated during rotation, or little backlash may be formed as compared with the coupling of the gears having no gradient.

According to an embodiment, after the second modified interlocking gear 234b_cha is coupled to the second main gear 233b, as in state 1405, the trailing area 234a_g4 (e.g., an area located in the -x-axis direction with respect to a central portion of the first modified interlocking gear 234a_cha), among the second modified gradient area 234b_g4 of the second modified interlocking gear 234b_cha and the modified gradient areas 234a_g3 and 234a_g4 of the first modified interlocking gear 234a_cha, may include a second gear coupling area 1412 in which the teeth are geared with each other face-to-face. Here, the gear teeth of 234b_g4 of the second modified interlocking gear 234b_cha that are formed thinner as they go from a central portion of the second modified interlocking gear 234b_cha in the -x-axis direction may be closely inserted into the trailing area 234a_g4 of the modified gradient area of the first modified interlocking gear 234a_cha that is formed such that the intervals between the teeth become gradually smaller as they go from a central portion of the first modified interlocking gear 234a_cha in the -x-axis direction. As an example, the gear teeth of the second modified gradient area 234b_g4 and the gear teeth of the trailing area 234a_g4 of the modified gradient area may surface-contact each other (e.g., contact each other with a constant surface). As another example, the second modified gradient area 234b_g4 of the second modified interlocking gear 234b_cha may have a shape, of which the intervals between the gear teeth become smaller as it goes from the -x-axis to the x-axis direction, and the trailing area 234a_g4 of the modified gradient area of the first modified interlocking gear 234a_cha may have a shape, of which the widths of the gear teeth become smaller as it goes from the -x-axis periphery to the central portion.

According to an embodiment, as in a state 1407, in a state in which the second main gear 233b, the second modified interlocking gear 234b_cha, and the first modified interlocking gear 234a_cha are geared with each other, one side of the first main gear 233a may include a third gear coupling area 1413 that is geared with one side (e.g., a leading area 234a_g3 of a modified gradient area of the first modified interlocking gear 234a_cha) of the first modified interlocking gear 234a_cha. According to an embodiment, a leading area 234a_g3 of a modified gradient area may be formed such that thicknesses of teeth (e.g., gear teeth of the first modified interlocking gear 234a_cha) become smaller (or intervals between the teeth become larger) as it goes from a central portion of the first modified interlocking gear 234a_cha to an x-axis periphery thereof. Correspondingly, thicknesses of teeth of a gradient area of the first main gear 233a may be formed to become smaller as they go from an x-axis periphery to a -x-axis periphery thereof, and the gradient area of the first main gear 233a may have a gradient shape corresponding to intervals of teeth of a leading area 234a_g3 of a modified gradient area. As an example, a leading area 234a_g3 of a modified gradient area of the first modified interlocking gear 234a_cha and a gradient area of the first main gear 233a may be geared with each other in a face-to-face state 1413.

As described above, a modified gear interlocking structure according to an embodiment may have a close contact state (a face-to-face contact state of gradient areas), through a first gear coupling area 1411 between the first main gear 233a and the first modified interlocking gear 234a_cha, a second gear coupling area 1412 between the second main gear 233b and the second modified interlocking gear 234b_cha, and a third gear coupling area 1413 between the first modified interlocking gear 234a_cha and the second modified interlocking gear 234b_cha. As an example, a hinge structure 202 may eliminate backlash of interlocking gears through a coupling of surfaces between the interlocking gears. As described in FIG. 10 above, the modified gear interlocking structure may be reciprocally linearly moved in the -x-axis direction or the x-axis direction while the foldable electronic device 100 is changed from the folded state to the unfolded state (or while being changed from the unfolded state to the folded state).

As described above, a foldable electronic device 100 according to an embodiment may include a first main gear 233a that is connected to a first housing 110 of FIG. 2 to be rotated in a first rotational direction, and includes first gear teeth (or first main gear teeth), of which a width of teeth disposed in a direction that is perpendicular to the first rotational direction becomes gradually larger (or smaller), a second main gear 233b that is connected to a second housing 120 of FIG. 2 and is rotated in a second rotational direction in response to a rotation of the first main gear 233a, and a first interlocking gear 234a that is disposed between the first main gear 233a and the second main gear 233b, and the first interlocking gear 234a may include second gear teeth (or teeth of a second interlocking gear), of which a width becomes gradually smaller (or larger) to be engaged with the first gear teeth of the first main gear 233a.

Meanwhile, the above-described main gears and interlocking gears may have the same number of gear teeth or may have different numbers of gear teeth, as needed. Furthermore, the numbers and thicknesses of gear teeth of interlocking gears for areas (e.g., an interlocking gradient area and a non-gradient area) may be formed differently.

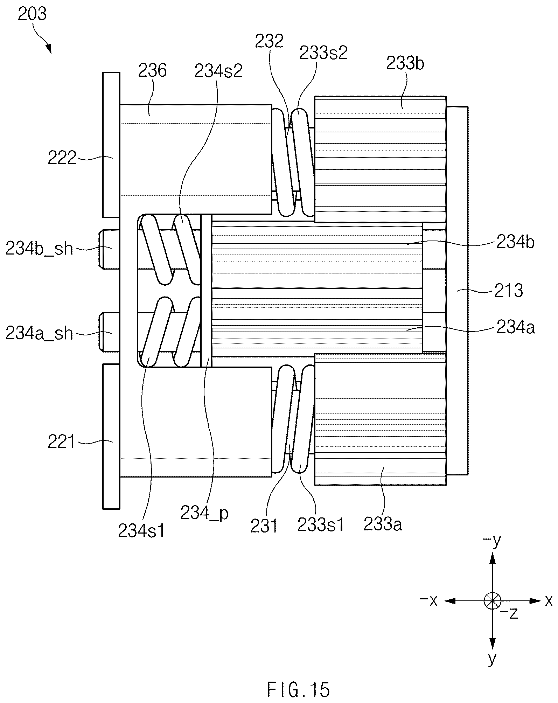

FIG. 15 is a view illustrating an example of some components of a hinge structure including a third type gear interlocking structure according to an embodiment.

Referring to FIGS. 1 to 15, a hinge structure 203 including a third type gear interlocking structure according to an embodiment may include at least a fixing bracket 213, arm members 221 and 222, a stopper 236, a first shaft 231, a first main gear 233a, a second shaft 232, a second main gear 233b, a third shaft 234a_sh, a first interlocking gear 234a, a fourth shaft 234b_sh, a second interlocking gear 234b, a first gear elastic body 234s1, a second gear elastic body 234s2, an interlocking gear support portion 234_p, a third gear elastic body 233s1, and a fourth gear elastic body 233s2. In the above-described third type gear interlocking structure, the remaining components other than a third gear elastic body 233s1 and a fourth gear elastic body 233s2 may be substantially the same as those of the first type gear interlocking structure described in FIG. 11.

The third gear elastic body 233s1 may be provided, for example, in a spring form (or a plate spring form) that may be held on the first shaft 231, and may exert an elastic force that presses the first main gear 233a from the -x axis in the x-axis direction while being supported by the stopper 236. When the first shaft 231 has a larger diameter than the third shaft 234a_sh, a diameter of the third gear elastic body 233s1 may be larger than a diameter of the first gear elastic body 234s1. The third gear elastic body 233s1 may be disposed between the stopper 236 and the first main gear 233a, and may provide a margin for movement by the first main gear 233a and the elasticity. In a gradient of the first main gear 233a, a thickness at a -x-axis periphery may be formed to be thinner than a thickness at an x-axis periphery, and in a gradient of the first interlocking gear 234a, a thickness at an x-axis periphery may be formed to be thinner than a thickness at a -x-axis periphery. Accordingly, in a state in which the first main gear 233a and the first interlocking gear 234a are engaged with each other, when the first shaft 231 is rotated, the first main gear 233a and the first interlocking gear 234a may be rotated while the first interlocking gear 234a is linearly moved in the -x-axis direction. In this process, the third gear elastic body 233s1 may exert elasticity by pressing the first main gear 233a in the x-axis direction, so that the first interlocking gear 234a may be more easily moved in the -x-axis direction. Additionally or alternatively, the third gear elastic body 233s1 may increase friction in a cam operation process of the first arm member 221 by transmitting an elastic force to the first arm member 221 through the stopper 236. Accordingly, the foldable electronic device 100 may more firmly provide a free-stop function (e.g., a function capable of maintaining an angle between the first housing 110 of FIG. 2 and the second housing 120 of FIG. 2 at a specific angle that is greater than 0 degrees and smaller than 180 degrees).

The fourth gear elastic body 233s2 may be formed to have the same shape and size as the third gear elastic body 233s1 (or to be similar within a specific range). The fourth gear elastic body 233s2 may perform a role that is similar to that of the third gear elastic body 233s1. For example, while the foldable electronic device 100 is changed from the unfolded state to the folded state by exerting an elastic force that presses the second main gear 233b in the x-axis direction (or in an opposite case), a frictional force may be increased during a cam operation of the second arm member 222 by providing an elastic force to the second arm member 222 through the stopper 236 while allowing easy rotation of the gears by reducing the frictional forces of the gradient surfaces of the second interlocking gear 234b and the second main gear 233b.

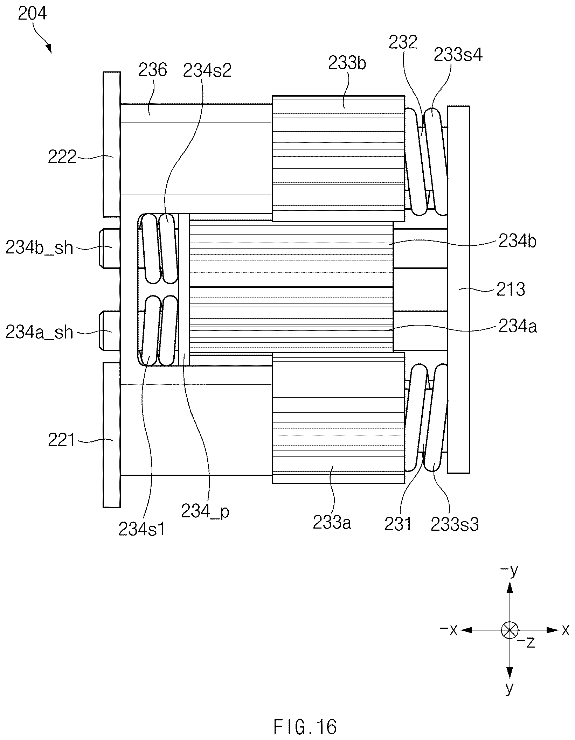

FIG. 16 is a view illustrating an example of a hinge structure including a fourth type gear interlocking structure according to an embodiment.

Referring to FIG. 16, a hinge structure 204 including a fourth type gear interlocking structure according to an embodiment may include at least a fixing bracket 213, arm members 221 and 222, a stopper 236, a first shaft 231, a first main gear 233a, a second shaft 232, a second main gear 233b, a third shaft 234a_sh, a first interlocking gear 234a, a fourth shaft 234b_sh, a second interlocking gear 234b, a first gear elastic body 234s1, a second gear elastic body 234s2, an interlocking gear support portion 234_p, a fifth gear elastic body 233s3, and a sixth gear elastic body 233s4. In the above-described fourth type gear interlocking structure, the remaining components other than a fifth gear elastic body 233s3 and a sixth gear elastic body 233s4 may be substantially the same as those of the first type gear interlocking structure described in FIG. 11 or the third type gear interlocking structure described in FIG. 15.

The fifth gear elastic body 233s3 may be provided in a form of a spring (or a leaf spring) that may be held on the first shaft 231. When the first shaft 231 has a larger diameter than the third shaft 234a_sh, a diameter of the fifth gear elastic body 233s3 may be similar to a diameter of the third gear elastic body 233s1 described above, and may be larger than a diameter of the first gear elastic body 234s1. The fifth gear elastic body 233s3 may exert an elastic force to press the first main gear 233a in the -x-axis direction while one side thereof is supported by the bracket 213 fixed to the hinge housing 150 of FIG. 2. Alternatively, the fifth gear elastic body 233s3 may exert an elastic force in a direction opposite to the first gear elastic body 234s1, so that a gear engagement between the first main gear 233a and the first interlocking gear 234a may be more firmly supported. As mentioned above, in a gradient of the first main gear 233a, a thickness at a -x-axis periphery may be formed to be thinner than a thickness at an x-axis periphery, and in a gradient of the first interlocking gear 234a, a thickness at an x-axis periphery may be formed to be thinner than a thickness at a -x-axis periphery. Accordingly, when the first shaft 231 is rotated in a state, in which the first main gear 233a and the first interlocking gear 234a are engaged with each other, the fifth gear elastic body 233s3 may press the first main gear 233a toward the first interlocking gear 234a, and a coupling of gradient areas of the first interlocking gear 234a, which is pressed in the x-axis direction by an elastic force of the first gear elastic body 234s1, may be closely formed. An elasticity of the fifth gear elastic body 233s3 may be transferred to the first arm member 221 through the stopper 236. The elasticity of the fifth gear elastic body 233s3 may increase a frictional force during a cam operation of the first arm member 221, and in response thereto, may be more firmly supported at a specific angle during a free-stop function of the foldable electronic device 100.

The sixth gear elastic body 233s4 may be formed to have the same shape and size as the fifth gear elastic body 233s3 (or to be similar within a specific range). The fourth gear elastic body 233s2 may perform a role that is similar to that of the third gear elastic body 233s1. For example, the sixth gear elastic body 233s4 may exert an elastic force to press the second main gear 233b in the -x-axis direction, so that backlash may be removed by more closely coupling gradient surfaces of the second interlocking gear 234b and the second main gear 233b while the foldable electronic device 100 is changed from the unfolded state to the folded state (or in an opposite case).

According to an embodiment, at least one of the third gear elastic body 233s1, the fourth gear elastic body 233s2, the fifth gear elastic body 233s3, and the sixth gear elastic body 233s4 may include a spring, a leaf spring, or a clip (e.g., a C-clip). For example, at least one of the elastic bodies may include a metal (e.g., stainless steel), rubber, or a plastic material.

According to the foldable electronic device 100 including the above-described gear interlocking structure, the second housing 120 of FIG. 2 may start to be rotated before the first housing 110 of FIG. 2 is rotated by 10 degrees or more, while the foldable electronic device 100 is folded from the unfolded state (e.g., a state, in which an included angle between the first housing 110 of FIG. 2 and the second housing 120 of FIG. 2 is 180 degrees, or a state, in which the first housing 110 of FIG. 2 and the second housing 120 of FIG. 2 are disposed to face the z-axis) due to the removal or reduction of backlash. According to an embodiment, an amount of lost motion may vary depending on an included angle between the first housing 110 of FIG. 2 and the second housing 120 of FIG. 2. For example, when the first housing 110 is rotated by about 2 to 8 degrees, the second housing 120 of FIG. 2 may start to be rotated. For example, the second housing 120 of FIG. 2 may start to be rotated before the first housing 110 of FIG. 2 is rotated by 5 degrees or more. In this regard, a change form of a width of gear teeth of the first main gear 233a (or the second main gear 233b) included in the gear interlocking structure may have a form, in which the change width gradually becomes larger or smaller while being 0.5 to 1.0 degrees (e.g., 0.7 degrees), and a minimum width of the gear teeth of the first interlocking gear 234a (or the second interlocking gear 234b) may have a thickness of 0.1 mm to 1.0 mm (e.g., 0.3 mm). Meanwhile, the above-described values may vary depending on a size change of the foldable electronic device 100 or a size change or a material change of the applied main gear.

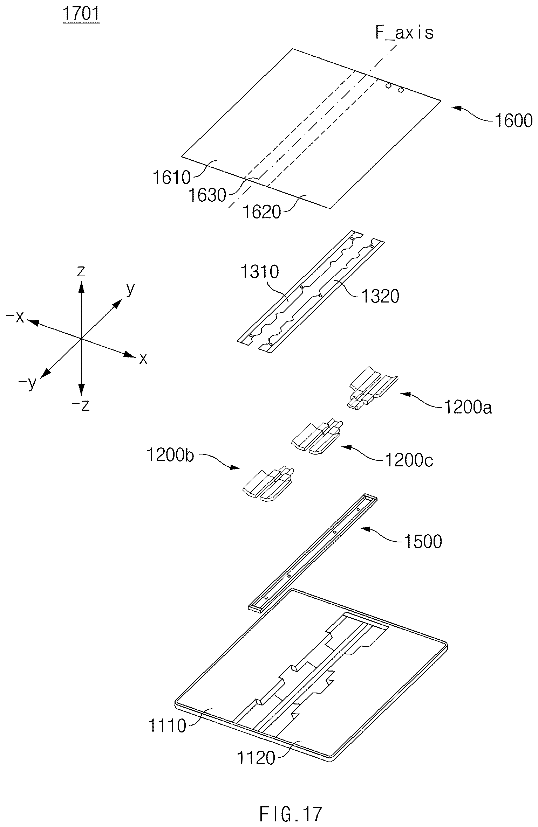

FIG. 17 is a view illustrating an example of another form of a foldable electronic device including a hinge structure having a gear interlocking structure according to an embodiment.

Referring to FIG. 17, a foldable electronic device 1701 (or an electronic device, a portable electronic device, a portable communication device, or a portable device) according to an embodiment may include a first housing 1110, a second housing 1120, a hinge housing 1500, wing plates 1310 and 1320 (or plates), a display 1600, and at least one hinge structure 1200a, 1200b, and 1200c.

According to the foldable electronic device 1701, a folding area of the display 1600 may form a waterdrop shape (or, when viewed from a front direction to a rear direction of the display 1600, a rearwardly convex waterdrop shape or a dumbbell shape), so that a folding radius (curvature) capable of preventing cracks or buckling in the folding area of the display 1600 may be secured. Furthermore, by disposing the dumbbell-shaped display folding area 1630 within a predetermined space of the housings 1110 and 1120, a gap between the housings 1110 and 1120, which are disposed in a 11-shape when the foldable electronic device 1701 is in the folded state, may be maintained at or less than a reference value, or the gap may be reduced compared to a gap of an existing foldable electronic device. Through this, a total size of the foldable electronic device 1701 may be reduced by reducing a gap between the housings 1110 and 1120, and introduction of foreign substances between the housings 1110 and 1120 may be prevented or alleviated.

Compared to the foldable electronic device 100 illustrated in FIGS. 1 and 2, the foldable electronic device 1701 of the above-described structure may have a structure, in which a major axis of a first area 1610 of the display 1600 and a major axis of a second area 1620 of the display 1600 are formed parallel to a folding axis F_axis, along which the display 1600 is folded. The folding axis F_axis may be applied in the same or similar manner to a center line of the display 160 described above with reference to FIGS. 1 and 2. Furthermore, the foldable electronic device 1701 of FIG. 17 may include a greater number of hinge structures 1200a, 1200b, and 1200c compared to the foldable electronic device 100 illustrated in FIGS. 1 and 2. At least one of the hinge structures 1200a, 1200b, and 1200c may include a gear interlocking structure, and as the gear interlocking structure, at least one of the gear interlocking structures described above with reference to FIGS. 3 to 16 may be employed. The at least one hinge structure 1200a, 1200b, and 1200c may be disposed in the hinge housing 1500, and at least some of the plurality of hinge structures 1200a, 1200b, and 1200c may have similar structures and shapes, and may have different structures and shapes from the remaining hinge structures. Alternatively, all three hinge structures 1200a, 1200b, and 1200c may have the same or similar structure, and directions in which they are disposed may be different. Meanwhile, in the illustrated drawings, a form in which three hinge structures 1200a, 1200b, and 1200c are disposed is exemplified, and the foldable electronic device 1701 may be disposed with two hinge structures or four or more hinge structures.

Embodiments of the document have been described, for example, based on spur gears, but are not limited thereto. According to an embodiment, at least one gear of the embodiments of the disclosure may include a helical gear, a bevel gear, a worm gear, or a screw gear. As an example, the plurality of interlocking gears (e.g., the first interlocking gear 234a and the second interlocking gear 234b) between the main gears may be replaced with at least one helical gear. A rotational direction of a main gear or an interlocking gear of the foldable electronic device 100 may vary depending on a type of gear to be applied.

According to an embodiment, when one helical gear is used as an interlocking gear, rotational directions of main gears on opposite sides may be set to be the same. According to an embodiment, when two helical gears are used as interlocking gears, rotational directions of main gears on opposite sides may be set to be different from each other.

The foldable electronic device 100 according to embodiments of the disclosure may include one or more folding axes. According to an embodiment, the electronic device 100 of the disclosure may be a multi-foldable electronic device that is foldable or unfoldable with respect to a plurality of folding axes. An electronic device 100 according to an embodiment may be folded in an in-folding manner or in an out-folding manner with respect to each of a plurality of folding axes. According to an embodiment, a gear to which a gradient is applied only to some of a plurality of folding axes may be provided. As an example, a gear to which a gradient is applied may be provided at a folding axis corresponding to in-folding, and a gear to which a gradient is not applied may be provided at a folding axis corresponding to out-folding. According to an embodiment, when two or more in-folding axes are included, two interlocking gears to which gradients are respectively applied may be disposed between two main gears to which gradients are respectively applied at a first in-folding axis, and four interlocking gears may be disposed between another two main gears to which gradients are respectively applied at a second in-folding axis. As an example, in an arrangement of four interlocking gears, two interlocking gears to which gradients are not applied may be disposed between two interlocking gears to which gradients are applied. According to an embodiment, gradients may be applied to all four interlocking gears.

Various embodiments of the disclosure may also be applied to rollable electronic devices, wearable electronic devices, and the like.

A portable communication device according to an embodiment of the disclosure may include a housing including a first housing, and a second housing configured to be movable relative to the first housing to be in a folded state or a non-folded state with respect to the first housing; a first main gear connected to the first housing and configured to be rotated in a first rotational direction, wherein the first main gear includes first main gear teeth, wherein each of the first main gear teeth have a width that gradually increases in a direction perpendicular to the first rotational direction; a second main gear connected to the second housing and configured to be rotated in a second rotational direction opposite to the first rotational direction in interlocking with movement of the first main gear; and a first interlocking gear provided between the first main gear and the second main gear and coupled to the first main gear to interlock movement of the first main gear with the second main gear, wherein the first interlocking gear includes teeth, each of the teeth of the first interlocking gear has a width that gradually decreases, and the teeth of the first interlocking gear are engaged with the first main gear teeth of the first main gear.

According to an embodiment, the first main gear and the first interlocking gear may remain in contact with each other while the second housing is moved to be in a folded state or a non-folded state with respect to the first housing.

According to an embodiment, the portable communication device may further include a first gear elastic body configured to apply a force to the first interlocking gear in a direction in which a width of teeth of the first interlocking gear gradually decreases.

According to an embodiment, the portable communication device may further include a bracket configured to support the first gear elastic body and coupled to at least one of shafts of the first main gear, the second main gear, or the first interlocking gear.

According to an embodiment, the first gear elastic body may be selected to have an elastic modulus of about 5000 to 9000 kgf/mm in consideration of the folded state or the non-folded state.

According to an embodiment, the portable communication device may further include a second gear elastic body configured to push the first main gear in a direction in which a width of the first main gear teeth gradually decreases.

According to an embodiment, the portable communication device may further include a bracket (e.g., a fixing bracket, an interlocking gear support portion, or a stopper) configured to support the second gear elastic body and coupled to at least one of shafts of the first main gear, the second main gear, or the first interlocking gear.

According to an embodiment, the portable communication device may include a second interlocking gear disposed between the first interlocking gear and the second main gear, coupled to the second main gear, and rotated in the first rotational direction, and the second interlocking gear may include teeth of the second interlocking gear, a width of which gradually decreases in a direction perpendicular to the first rotational direction.

According to an embodiment, the second main gear may include second main gear teeth, a width of which gradually increases such that the second main gear teeth are engaged with the teeth of the second interlocking gear.

According to an embodiment, each of the first interlocking gear and the second interlocking gear may further include a non-gradient area, of which a width of teeth substantially does not change, and the first interlocking gear and the second interlocking gear are rotated while being engaged with each other in the non-gradient area.

According to an embodiment, the first interlocking gear and the second interlocking gear may be disposed such that they do not engage with the first main gear and the second main gear at the non-gradient area.

According to an embodiment, the first interlocking gear and the second interlocking gear may have a gap, by which the first interlocking gear and the second interlocking gear are spaced apart from each other in the non-gradient area, during at least a partial section in which the second housing is moved to the folded state or the non-folded state with respect to the first housing.

According to an embodiment, the number of gear teeth of the non-gradient area of the first interlocking gear may be different from the number of teeth of the first interlocking gear.

According to an embodiment, the second housing is rotated in an opposite direction to the first housing before the first housing may be rotated by 5 degrees or more.

According to an embodiment, a width of the first main gear teeth may gradually increase such that the first main gear teeth have an angle of 0.5 to 1.0 degrees.

According to an embodiment, a narrowest portion of widths in the teeth of the first interlocking gear may have a thickness of 0.3 to 0.5 mm.

According to an embodiment, the first interlocking gear may include a gradient area in which a width of the gear teeth gradually decreases, and a non-gradient area in which a width of the gear teeth is maintained constant.

According to an embodiment, the number of gear teeth of the non-gradient area of the first interlocking gear (or the second interlocking gear) may be different from the number of teeth of the first main gear (or the second main gear). As an example, the number of gear teeth of the non-gradient area of the first interlocking gear (or the second interlocking gear) may be smaller than the number of gear teeth of the first main gear (or the second main gear).

A portable communication device according to an embodiment of the disclosure may include a housing including a first housing, and a second housing configured to be movable relative to the first housing to be in a folded state or a non-folded state with respect to the first housing; a first main gear connected to the first housing and configured to be rotated in a first rotational direction, wherein the first main gear includes first main gear teeth, and each of the first main gear teeth has a width that gradually increases in a direction perpendicular to the first rotational direction; a second main gear connected to the second housing and configured to be rotated in a second rotational direction opposite to the first rotational direction in interlocking with movement of the first main gear; a first interlocking gear provided between the first main gear and the second main gear and coupled to the first main gear to interlock movement of the first main gear with the second main gear, wherein the first interlocking gear includes teeth, each of the teeth of the first interlocking gear has a width that gradually decreases, the teeth of the first interlocking gear are engaged with the first main gear teeth of the first main gear, and each of the teeth of the first interlocking gear include a first interlocking gradient area having a width that gradually decreases, and a first non-gradient area connected to the first interlocking gradient area and having a constant width; and a second interlocking gear provided between the second main gear and the first interlocking gear and coupled to the first interlocking gear to interlock movement of the first interlocking gear with the second main gear, wherein the second interlocking gear includes teeth, and each of the teeth of the second interlocking gear has a second non-gradient area engaged with the first non-gradient area of the teeth of the first interlocking gear.

According to an embodiment, the second interlocking gear may include a second interlocking gradient area connected to the second non-gradient area and having a width that gradually decreases, and the second main gear may include second main gear teeth, of which a width gradually increases, to be geared with the second interlocking gradient area.

According to an embodiment, the portable communication device may further include a first gear elastic body configured to press the first interlocking gear toward the first main gear, and a second gear elastic body configured to press the second interlocking gear toward the second main gear.

According to an embodiment, the portable communication device may further include a third gear elastic body configured to press the first main gear toward the first interlocking gear, and a fourth gear elastic body configured to press the second main gear toward the second interlocking gear.

A portable communication device according to an embodiment of the disclosure may include a first housing, a second housing, a hinge structure connecting the first housing and the second housing, and a flexible display positioned on the first housing, the second housing, and the hinge structure, the hinge structure may include a first main gear disposed on a first shaft, a second main gear disposed on a second shaft disposed parallel to the first shaft, a first interlocking gear disposed between the first main gear and the second main gear and formed on a third shaft disposed parallel to the first shaft, and a second interlocking gear disposed between the first main gear and the second main gear and formed on a fourth shaft disposed parallel to the second shaft, and a width of each tooth of gear teeth of the first main gear may be formed to gradually increase in thickness in a first direction from one side periphery of the first shaft toward an opposite side periphery, and a width of each tooth of gear teeth of the first interlocking gear, which is geared with the first main gear, may be formed to gradually decrease in thickness in a second direction opposite to the first direction.

According to an embodiment, a height of gear teeth of the first main gear may be formed to gradually decrease in the first direction.

According to an embodiment, a height of gear teeth of the first interlocking gear may be formed to gradually decrease in the second direction.

According to an embodiment, the portable communication device may further include a first gear elastic body disposed on the third shaft to press the first interlocking gear in the second direction.

According to an embodiment, a width of each tooth of gear teeth of the second main gear may be formed to gradually increase as it goes in the first direction.

According to an embodiment, a width of each tooth of gear teeth of the second interlocking gear may be formed to gradually decrease as it goes in the second direction.

According to an embodiment, the portable communication device may further include a second gear elastic body disposed on the fourth shaft to press the second interlocking gear in the second direction.

According to an embodiment, the portable communication device may further include an interlocking gear support portion in which the third shaft and the fourth shaft are held and which supports the first gear elastic body and the second gear elastic body.

According to an embodiment, a height of gear teeth of the second main gear may be formed to gradually decrease as it goes in the first direction.

According to an embodiment, a height of gear teeth of the second interlocking gear may be formed to gradually decrease as it goes in the second direction.

According to an embodiment, the first interlocking gear may include a first interlocking gradient area in which gear teeth having widths gradually decreasing are disposed, and a first non-gradient area connected to the first interlocking gradient area and in which widths of the gear teeth are maintained constant.

According to an embodiment, the second interlocking gear may include a second interlocking gradient area in which gear teeth having widths gradually decreasing are disposed, and a second non-gradient area connected to the second interlocking gradient area, in which widths of the gear teeth are maintained constant, and geared with the first non-gradient area.

According to an embodiment, a gap may be formed between the first non-gradient area and the second non-gradient area during at least a partial section in which the foldable electronic device is folded from an unfolded state.

According to an embodiment, a gap may be formed between gear teeth of the first interlocking gear disposed in the first interlocking gradient area and gear teeth of the second interlocking gear disposed in the second interlocking gradient area during at least a partial section in which the foldable electronic device is folded from an unfolded state.

A portable communication device according to an embodiment of the disclosure may include a flexible display; a first housing for accommodating a first portion of the flexible display; a second housing for accommodating a second portion of the flexible display; and a hinge structure provided substantially between the first housing and the second housing, wherein the hinge structure includes: a first main gear connected to the first housing and configured to be rotated in a first rotational direction in response to movement of the first housing, wherein the first main gear includes first main gear teeth, and each of the first main gear teeth has a width that varies along a rotation axis of the first main gear; a second main gear connected to the second housing and configured to be rotated in a second rotational direction in response to movement of the second housing, wherein the second main gear includes second main gear teeth, and each of the second main gear teeth has a width that varies along a rotation axis of the second main gear; a first interlocking gear provided between the first main gear and the second main gear and coupled to the first main gear, wherein the first interlocking gear includes teeth, and each of the teeth of the first interlocking gear has a width that varies along a rotation axis of the first interlocking gear; and a second interlocking gear provided between the first main gear and the second main gear and coupled to the second main gear, wherein the second interlocking gear includes teeth, and each of the teeth of the second interlocking gear has a width varies along a rotation axis of the second interlocking gear.

According to an embodiment, the first interlocking gear may include a first area corresponding to teeth of the first interlocking gear and a second area including teeth of another interlocking gear, of which a width is substantially constant, with respect to a direction of a rotation axis of the first interlocking gear.

According to an embodiment, the second housing may start to be moved in a direction approaching the first housing before the first housing is moved by 5 degrees or more.

According to an embodiment, the electronic device of various embodiments disclosed in the disclosure may include a mobile electronic device, and may be provided as being included in a computer program product related to the operation of the mobile electronic device. The computer program product may be traded between a seller and a buyer as a product. The computer program product may be distributed in the form of a machine-readable storage medium (e.g., compact disc read only memory (CD-ROM)) or may be distributed (e.g., downloaded or uploaded), through an application store (e.g., PlayStore^{™}), directly between two user devices (e.g., smartphones), or online. In the case of on-line distribution, at least part of the computer program product may be at least temporarily stored in the machine-readable storage medium such as the memory of a manufacturer's server, an application store's server, or a relay server or may be generated temporarily.

According to various embodiments, each component (e.g., a module or a program) of the above-described components may include a single entity or a plurality of entities, and some of the plurality of objects may be separately arranged on other components. According to various embodiments, one or more components of the above-described components or operations may be omitted, or one or more other components or operations may be added. Alternatively or additionally, a plurality of components (e.g., a module or a program) may be integrated into one component. In this case, the integrated component may perform one or more functions of each component of the plurality of components in the manner same as or similar to being performed by the corresponding component of the plurality of components prior to the integration. According to various embodiments, operations executed by modules, programs, or other components may be executed by a successive method, a parallel method, a repeated method, or a heuristic method. Alternatively, at least one or more of the operations may be executed in another order or may be omitted, or one or more operations may be added.

## Claims

1. A portable communication device comprising:
a housing defining at least a portion of an external appearance of the portable communication device, wherein the housing comprising a first housing, and a second housing configured to be movable relative to the first housing to be in a folded state or a non-folded state with respect to the first housing;
a first main gear connected to the first housing and configured to be rotated in a first rotational direction, wherein the first main gear comprises first main gear teeth, wherein each of the first main gear teeth have a width that gradually increases in a direction perpendicular to the first rotational direction;
a second main gear connected to the second housing and configured to be rotated in a second rotational direction opposite to the first rotational direction in interlocking with movement of the first main gear; and
a first interlocking gear provided between the first main gear and the second main gear and coupled to the first main gear to interlock movement of the first main gear with the second main gear, wherein the first interlocking gear comprises teeth, each of the teeth of the first interlocking gear has a width that gradually decreases, and the teeth of the first interlocking gear are engaged with the first main gear teeth of the first main gear.

2. The portable communication device of claim 1, wherein the first main gear and the first interlocking gear are in contact with each other while the second housing is moved to be in the folded state or the non-folded state.

3. The portable communication device of claim 1, further comprising:
a first gear elastic body configured to apply a force to the first interlocking gear in a direction in which the width of the teeth of the first interlocking gear gradually decreases.

4. The portable communication device of claim 3, further comprising:
a bracket configured to support the first gear elastic body, the bracket being coupled to at least one shaft the first main gear, the second main gear, or the first interlocking gear.

5. The portable communication device of claim 4, wherein the first gear elastic body has an elastic modulus of about 5000 to 9000 kgf/mm.

6. The portable communication device of claim 1, further comprising:
a second gear elastic body configured to push the first main gear in a direction in which the width of the first main gear teeth gradually decreases.

7. The portable communication device of claim 1, further comprising:
a second interlocking gear provided between the first interlocking gear and the second main gear, the second interlocking gear being coupled to the second main gear, and the second interlocking gear being rotated in the first rotational direction, wherein the second interlocking gear comprises the teeth, and each of the teeth of the second interlocking gear has a width that gradually decreases in a direction perpendicular to the first rotational direction.

8. The portable communication device of claim 7, wherein the second main gear comprises second main gear teeth, each of the second main gear teeth have a width that gradually increases, and the second main gear teeth are engaged with the teeth of the second interlocking gear.

9. The portable communication device of claim 7, further comprising:
each of the first interlocking gear and the second interlocking gear further comprises a non-gradient area in which a width of teeth of the first interlocking gear and the second interlocking gear substantially does not change, wherein the first interlocking gear and the second interlocking gear are rotated while being engaged with each other in the non-gradient area.

10. The portable communication device of claim 9, wherein the first interlocking gear and the second interlocking gear are spaced apart from each other in the non-gradient area by a gap, during at least a partial section in which the second housing is moved to the folded state or the non-folded state.

11. The portable communication device of claim 9, wherein a number of gear teeth of the first interlocking gear in the non-gradient area is different from a number of the teeth of the first interlocking gear.

12. The portable communication device of claim 1, wherein the second housing is rotated in an opposite direction to the first housing before the first housing is rotated by at least 5 degrees.

13. The portable communication device of claim 1, wherein a width of the first main gear teeth gradually increases such that the first main gear teeth have an angle of 0.5 to 1.0 degrees.

14. The portable communication device of claim 1, wherein the first interlocking gear comprise a first interlocking gradient area having a width that gradually decreases and a first non-gradient area having a constant width

15. The portable communication device of claim 14, wherein a number of gear teeth of the first interlocking gear in the non-gradient area is different from a number of the teeth of the first main gear.
